# EUROPEAN PATENT SPECIFICATION

(11) **EP 0 333 194 B1**
(45) Date of publication and mention of the grant of the patent: **18.06.1997**
(21) Application number: 89104735.9
(22) Date of filing: 16.03.1989
(51) Int. Cl.: H03J 7/18

(54) **Radio data system receiver**
Empfänger für ein Radio-Daten-System
Récepteur pour système RDS

(30) Priority: 17.03.1988 JP 64315/88; 20.07.1988 JP 180525/88
(43) Date of publication of application: 20.09.1989
(73) Proprietor: SANYO ELECTRIC CO., LTD., Moriguchi-shi, Osaka (JP); Tottori Sanyo Electric Co., Ltd., Tottori-shi Tottori-ken (JP)
(72) Inventor: Okazaki, Yuuzou, Tottori-shi Tottori-ken (JP)
(74) Representative: Glawe, Delfs, Moll & Partner

(56) References cited:
- EP-A- 0 092 055
- EP-A- 0 123 154
- EP-A- 0 211 366
- DE-A- 3 620 428
- US-A- 4 069 455
- FUNKTECHNIK, vol. 41, no. 2, February 1986, pages 70-73, Heidelberg, DE; R. JAGBERGER: "Zwei Herzen in einer Brust: Autoradio mit zwei Verkehrsfunkempfängern"

## Description

### BACKGROUND OF THE INVENTION

### Field of the Invention

The present invention relates to a receiver, and more specifically, it relates to a receiver which can automatically change the frequency of a currently received program signal to another frequency for the same program signal when its receiving state is deteriorated, for example when a signal strength becomes lower than predetermined level.

### Description of the Background Art

In a conventional broadcasting system called Autofahrer Rundfunk Information (ARI), which is carried out in West Germany etc., a data signal for identifying a traffic information station is multiplexed with an FM radio signal to be on the air.

In this ARI system, the third harmonic (57 KHz) of a pilot signal (19 KHz) for FM broadcasting serves as a subcarrier, which is amplitude-modulated by a data signal for identifying a traffic information station and frequency-converted into a main carrier, to be multiplexed with an FM radio signal and transferred. In a receiving area, the signal for identifying the traffic information station multiplexed with the FM radio signal is so demodulated as to facilitate receiving of a program signal supplying traffic information.

However, the ARI system provides only information relating to identification of the traffic information station, but supplies no other service.

Therefore, another system called Radio Data System (RDS) has been proposed to perform carrier suppression type amplitude modulation on the subcarrier of 57 KHz by a data signal which is biphase-coded to be 90° out of phase with that of the ARI system and multiplex a double-sideband signal of the modulated signal with an FM radio signal for transmission. The RDS standard is described in "Specifications of the Radio Data System RDS for VHF-FM Sound Broadcasting" by Europe Broadcasting Union (EBU), EBU Document Tec. 3244-E, Mar. 1984. According to this document, one group of service data (hereinafter referred to as RDS data) supplied in the RDS is defined by four blocks, each of which is formed by 26 bits.

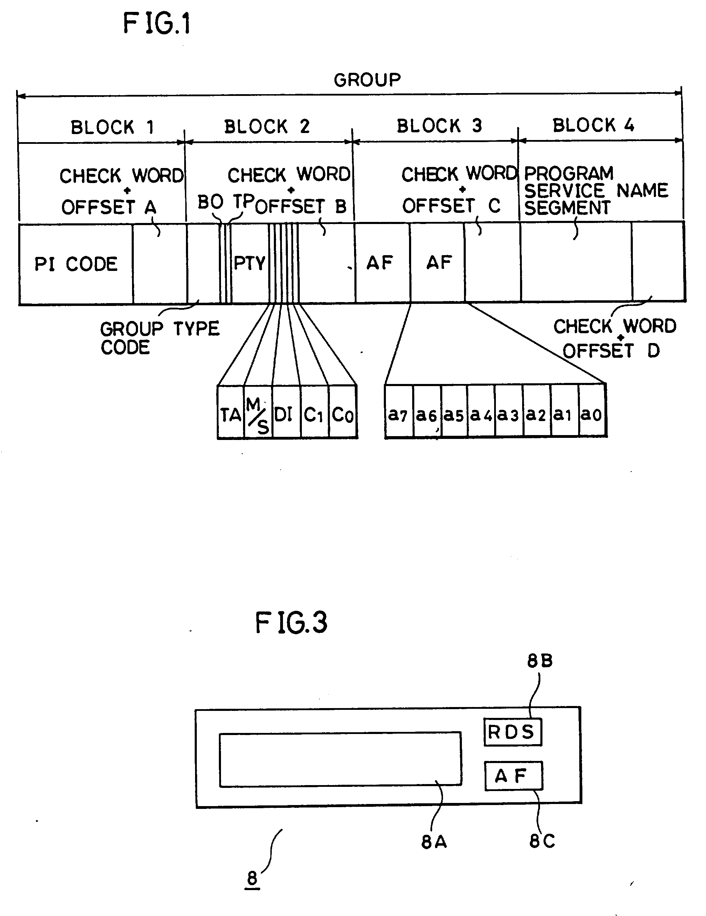

As shown in Fig. 1, the respective blocks include 16-bit information words, as well as 10-bit check words and offset words. The receiving area can receive various services by data-demodulating the information words. The check words are codes for detecting data errors and correcting the same. The offset words are data indicating start points of the blocks and the numbers of the blocks within the group.

In response to the data format shown in Fig. 1, basic information of the RDS data is now described.

The first block is provided with program identification codes (PI codes). The PI codes are formed by 16 bits of:
(1) national code (four bits);
(2) broadcasting range code (four bits); and
(3) program reference number code (eight bits)
That is, the PI codes include information as to which country gives a currently received program signal, whether or not the same program signal is given in other countries, whether the program is local or major, and the like, in the form of code data based on predetermined rules. Thus, the same program signal can be recognized through these data.

The second block is supplied with five-bit group type identification codes formed by a group type code (four bits) and a version code BO (one bit). The group type identification codes are adapted to identify the content of subsequently transmitted data. In theory, 2⁵ = 32 group types can be identified by the group type identification codes of five bits. However, definition is currently given to nine group types, and other group types are still undefined to make provision for future use.

In addition to the group type identification codes, the second block is provided with:
(1) traffic program code (TP code: one bit);
(2) program type code (PTY code: five bits);
(3) traffic announce code (TA code: one bit);
(4) music/speech switching code (M/S code: one bit);
(5) decoder identification code (DI code: one bit); and
(6) program service name segment address codes (C1 and C0: two bits)

Within the above data, the TP code and the TA code are combined with each other to indicate whether or not a station giving the currently received program signal has a traffic information station, or whether or not traffic information is currently on the air.

The PTY code is adapted to identify 32 program types (music, news, sport etc.) of zero to 31, and defined in response to predetermined rules.

The M/S code indicates that a speech is on the air when the same is "0", while indicating that music is on the air when the same is "1".

The DI code of one bit is adapted to supply decode information for demodulating broadcasting waves coming into the receiver, and four-bit information (16 decode data) can be obtained by repeatedly receiving the DI code four times.

The program service name segment address codes C1 and C0 are varied in function with the aforementioned group types, while the same are adapted to indicate addresses of PS codes as hereinafter described in this embodiment.

The third block is provided with a pair of eight-bit alternative frequency codes (AF codes). For convenience of illustration, these AF codes are referred to as first and second AF codes.

The AF codes are adapted to transmit the number of other broadcasting stations (hereinafter referred to as AF stations) giving the same program signal as the currently received one and frequency data thereof. The eight-bit AF codes can express numbers zero to 255, and within these numbers, zero to 205 correspond to frequency data per 100 KHz as follows:

| Number | AF Code | Carrier Frequency |
|---|---|---|
| 0 | 00000000 | 87.5 MHz |
| 1 | 00000001 | 87.6 MHz |
| . | . | . |
| . | . | . |
| 204 | 11001100 | 107.9 MHz |
| 205 | 11001101 | filler code |

Within the remaining numbers, Nos. 224 to 249 are provided with other meaning, in correspondence to the number of the AF stations as follows:

| Number | AF Code | Meaning |
|---|---|---|
| 224 | 11100000 | No AF Station |
| 225 | 11100001 | One AF Station |
| . | . | . |
| . | . | . |
| 249 | 11111001 | 25 AF Stations |

Consider the case of transmitting information relating to four AF stations, for example. In this case, No. 228 indicating the number of the AF stations is supplied to the first AF code in the RDS data transmitted at the start, and the number indicating the carrier frequency is supplied to the second AF code. Second and third frequency data are supplied to the first and second AF codes in the subsequently transmitted RDS data. In the finally transmitted RDS data, the first AF code is supplied with the fourth frequency data and the second AF code is supplied with the filler code (No. 205). Thus, transmission of the AF codes is completed. Thereafter similar transmission is repeated in a cyclic manner.

Thus, the frequency data of the other stations giving the same program signal as the currently received one can be obtained in the receiving area by repeatedly receiving the AF codes and demodulating the same.

The fourth block is provided with program service name codes (PS codes), through which the name of a broadcasting station is transmitted in the form of ASCII codes. Since the ASCII codes require eight bits of binary codes for one character, the fourth block can transmit only ASCII code for two characters. In the RDS data providing the station name in eight characters, the PS codes must be received four times to obtain information for eight characters. At this time, the program service name segment address codes C1 and C0 determine the numbers of currently received PS codes within the eight characters. Therefore, it is possible to demodulate the station name formed by eight characters by repeating demodulation of the PS codes four times.

When the signal strength of a program signal currently received in a radio receiver becomes lower than predetermined level, the tuning frequency can be changed to another frequency for the same program signal through the AF codes in the aforementioned RDS, thereby to continuously receive the radio program signal.

### Description of the Prior Art

For example, Japanese Patent Laying-Open Gazette No. 136830/1988 discloses a radio receiver which has the function of automatically changing a tuning frequency of a program signal to another frequency for the same program signal through AF codes. When the signal strength of a program signal currently received in the conventional radio receiver is lowered, the said tuning frequency is stored in a memory while sequential scanning is made in the receive band. Such scanning is stopped upon detection of a broadcasting frequency having field strength exceeding a predetermined level. RDS data from a station corresponding to the broadcasting frequency are demodulated to read a frequency list included therein. Frequency data included in the frequency list are sequentially compared with those previously stored in the memory, and if there are coincident frequency data, the program signal is continuously received from this station. If no coincident frequency data are detected as the result of comparison, further scanning is made in the receive band to repeat operation similar to the above until coincident frequency data are detected.

However, about seven seconds are required to read a frequency list included in RDS data for each station. In the aforementioned conventional receiver, an alternative broadcasting station is scarcely detected at the start of scanning in the receive band. Assuming that the alternative station is detected in the third station, it takes 21 seconds to satisfy a requesy for changing the tuning frequency. In this case, the program signal is interrupted for a long time to keep the listener in suspense. Further, important information might be missed during the interruption.

EP-A-0 211 366 discloses a receiver reproducing a broad casting station wherein a list of frequency data of other stations giving the same program is extracted from a main memory, this list being stored in an alternative program memory, search means searching for frequency data of stations among said other stations whose transmitter is located within a given distance to the transmitter of the broadcasting station being currently received, level detecting means detecting the signal strength of the reproduced program signal, decision means detecting whether or not the receiving state is deteriorating and change means controlling the tuning frequency of the receiving means. A similar receiver including two tuner circuits is known from EP-A-0 092 055.

According to these documents data concerning broadcast stations broadcasting the same program as the program currently being received from the station a are labeled in a memory in advance. When it is detected that the signal level of the signal currently being received from the station a is lower than the predetermined level, the data concerning another broadcast station b is read out from the memory to receive the broadcasting signal from this broadcasting station b and the received signal level is detected. As a result, the reception of the broadcasting signal from the broadcast station a is continued if the reception from the station a is in a better condition, while the reception of the broadcasting signal is switched to the broadcast station b if the reception form the station b is in a better condition.

After it is determined to continue the reception from the station a based on the result of comparison between the received signal levels from the stations a and b, the received signal strength from the station a is detected again. If it is detected again that the detected signal strength is lower than the predetermined level, the comparison with the received signal from the station c which is different from the station b is made.

Therefore, even if the reception from the station b is not in a better condition than the reception form the station c the reception from the station b must be made once before the reception is switched to the station c so that the reception from the initial station a is continued in the deteriorated condition during that period.

In other words, the data of all stations receivable in a particular area are fixedly stored in the memory. During receipt of a particular program all stations sending the same program are labeled in this memory, and the currentaly received signal is compared with one of the stations labeled in the memory. In case the signal strength of the currently received signal is not sufficient it is switched to a single signal which may be received with better signal strength. This process is repeated sequentially.

### SUMMARY OF THE INVENTION

Accordingly, an object of the present invention is to reduce a time required for changing a tuning frequency of a program signal to another frequency for the same program signal upon generation of a request for changing the tuning frequency.

This object is achieved by a receiver for receiving a broad casting signal according to claim 1. The dependent claims are related to further advantageous aspects of the present invention.

Briefly stated, a broadcasting signal coming into the inventive receiver includes various service data in addition to program signal. The service data include at least a list of frequency data of other broadcasting stations giving the same program signal as the currently received one. The receiver extracts the service data from the broadcasting signal, to previously search the frequency data list included in the service data for frequency data which is at a signal strength exceeding a predetermined value. When deterioration of a receiving state in the receiving means is decided and a request for changing the tuning frequency is generated, the tuning frequency of the receiving means is controlled through the previously searched frequency data, thereby to change the currently received program signal to that of the same program coming from another station.

According to the present invention, previously searched is frequency data, of which signal strength is in excess of a predetermined level, of another station giving the same program signal as the currently received one, whereby the tuning frequency can be extremely quickly changed when a request for changing the tuning frequency is generated upon deterioration of the receiving state. Consequently, an interruption period receiving of the program signal is extremely shortened as compared with the conventional receiver. Thus, no inconvenience is caused to the listener. Further, the listener will not miss important information.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 illustrates a data format in a group of RDS data;
Fig. 2 is a block diagram showing the structure of a first embodiment of the present invention;
Fig. 3 illustrates the structure of an indicator shown in Fig. 2;
Figs. 4A to 4D are flow charts for illustrating the operation of the first embodiment of the present invention;
Figs. 5A to 5D are flow charts for illustrating the operation of a second embodiment of the present invention;
Fig. 6 is a block diagram showing the structure of a third embodiment of the present invention;
Fig. 7 is a block diagram showing the structure of a fourth embodiment of the present invention;
Figs. 8A to 8C are flow charts for illustrating the operation of the fourth embodiment of the present invention;
Fig. 9 is a block diagram showing the structure of a fifth embodiment of the present invention;
Figs. 10A and 10B are timing charts for illustrating the operation of the fifth embodiment of the present invention;
Figs. 11A to 11C are flow charts for illustrating the operation of the fifth embodiment of the present invention;
Figs. 12A to 12D are flow charts for illustrating the operation of a sixth embodiment of the present invention; and
Fig. 13 illustrates other exemplary storage areas of a data memory.

### DESCRIPTION OF THE PREFERRED EMBODIMENTS

### First Embodiment

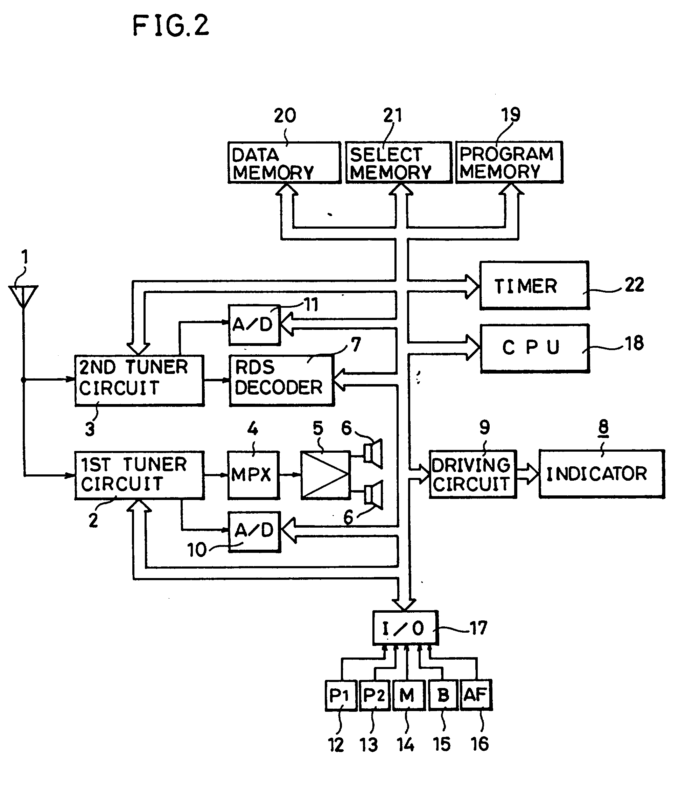

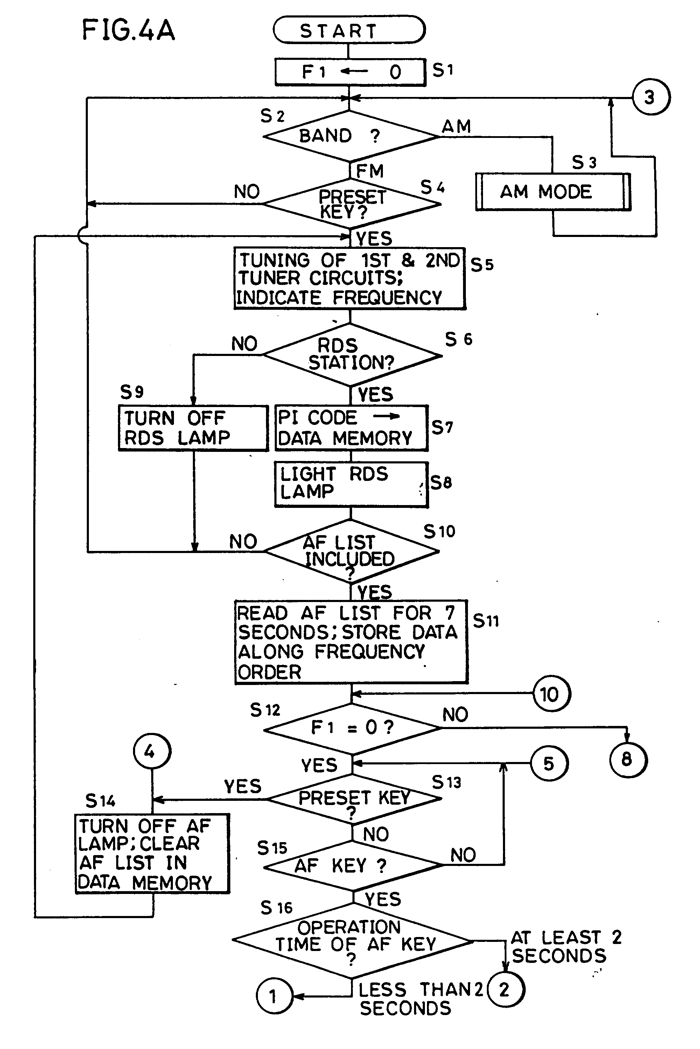

The structure of a radio receiver according to a first embodiment of the present invention is now described with reference to Fig. 2. A signal which is induced to an antenna 1 is supplied to first and second tuner circuits 2 and 3. The first and second tuner circuits 2 and 3 respectively have local oscillation circuits which are formed by PLL synthesizers, to AM-demodulate and FM-demodulate the signal received from the antenna 1. A multiplexer 4 separates the output signal from the first tuner circuit 2 into a right signal and a left signal. The output signals from the multiplexer 4 are supplied to an amplifier 5, to be amplified therein. The output signals from the amplifier 5 are supplied to a pair of speakers 6. An RDS decoder 7 demodulates RDS data from the FM-demodulated output of the second tuner circuit 3 while regenerating clocks, to perform group synchronization and error correction of the demodulated RDS data. An indicator 8 includes a frequency indicator 8A, an RDS lamp 8B and an AF lamp 8C, as shown in Fig. 3. This indicator 8 is driven by a driving circuit 9. A-D converters 10 and 11 are adapted to A-D convert field strength signals from the first and second tuner circuits 2 and 3 respectively.

Preset keys 12 and 13, a memory key 14, a band key 15 and an AF key 16 are connected to an I/O port 17. The preset keys 12 and 13 are adapted to command readout of frequency data stored in corresponding areas of a data memory 20 respectively. The memory key 14 is adapted to store data of a current tuning frequency of the first tuner circuit 2 in the data memory 20. The band key 15 is adapted to switch AM and FM bands. The AF key 16 is adapted to command transition to an AF search mode or an AF indication mode and release of the AF search mode or the AF indication mode. Key code data obtained from the keys 12 to 16 are inputted in a data bus through the I/O port 17.

A CPU 18 is connected with the first and second tuner circuits 2 and 3, the RDS decoder 7, the driving circuit 9, the A-D converters 10 and 11, a program memory 19, the data memory 20, a select memory 21 and a timer 22 through the aforementioned data bus. The CPU 18 controls the respective circuits in accordance with a program written in the program memory 19, which is formed by a ROM (read only memory). The data memory 20, which is formed by a RAM (random access memory), stores various data required for data processing through the CPU 18. The data memory 20 includes areas corresponding to respective ones of the preset keys 12 and 13 and storing frequency data to be transmitted to the local oscillation circuits of the first and second tuner circuits 2 and 3, areas for storing a frequency list (including 25 frequency data at the maximum) of AF stations included in the RDS data and areas for storing PI codes, as storage areas which are particularly of interest to the present invention. Within the frequency data of the AF stations stored in the data memory 20, those at signal strengths exceeding a predetermined value are stored in the select memory 21. The timer 22 is employed for measurement of time in detection of the fact that the signal strength of the first tuner circuit 2 is continuously lowered at least for a constant period (e.g., 22 seconds).

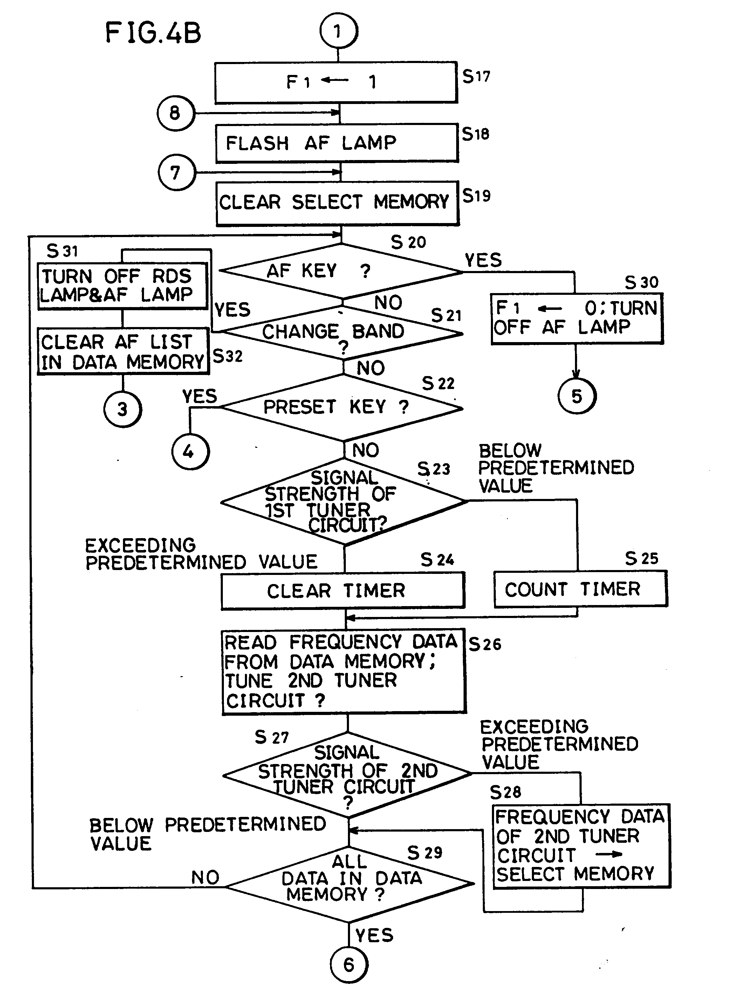

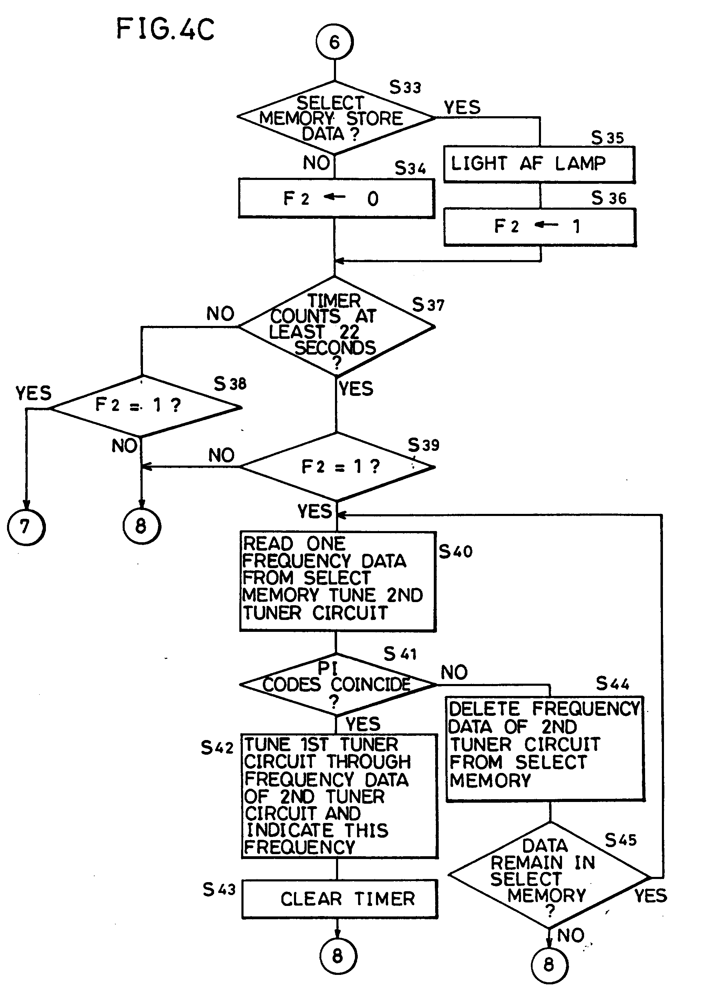

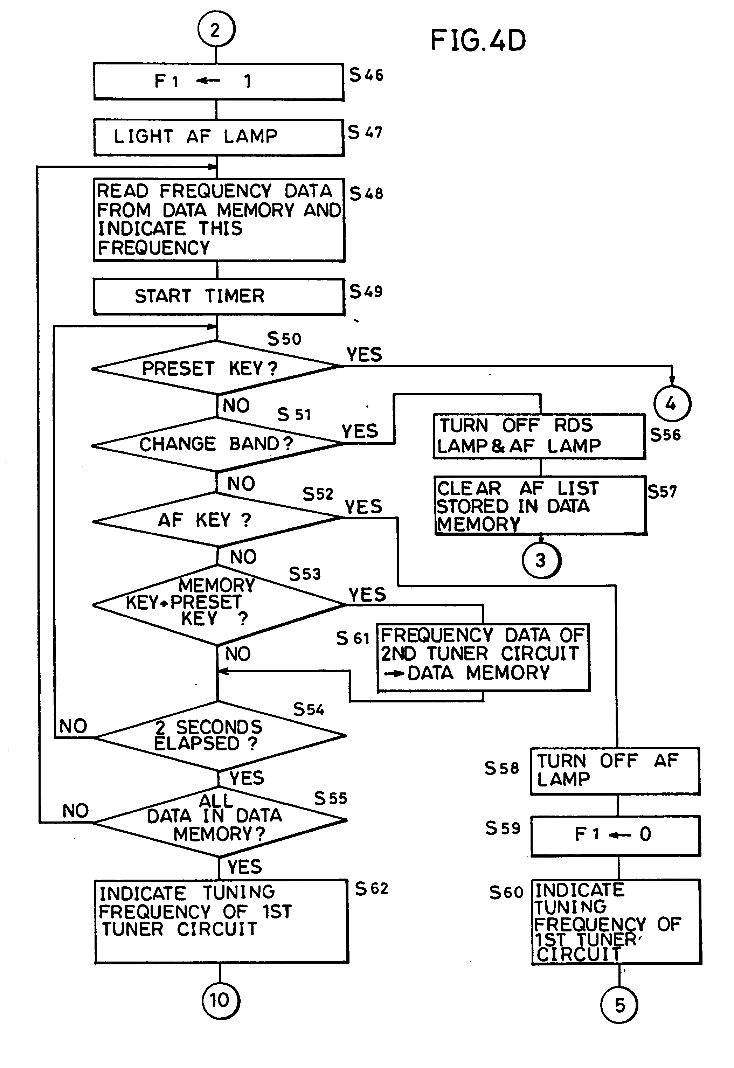

The operation of the first embodiment is now described with reference to flow charts shown in Figs. 4A to 4D.

Upon power supply, the CPU 18 sets zero in a flag register F1, which is provided in the CPU 18, for example (step S1). Thereafter the band key 15 selects the FM band and the preset key 12 or 13 is operated, whereby frequency data is read from the storage area of the data memory 20 corresponding to the operated preset key 12 or 13 and transmitted to the local oscillation circuits of the first and second tuner circuits 2 and 3 and the driving circuit 9. Thus, the first and second tuner circuits 2 and 3 are tuned to the said frequency, which in turn is indicated on the frequency indicator 8A (steps S2, S4 and S5). Then the operation step is upgraded to S6. At the step S6, a decision is made as to whether or not a station communicating with the first and second tuner circuits 2 and 3, i.e., a broadcasting station corresponding to the tuning frequency of the tuner circuits 2 and 3, is an RDS station (broadcasting station transmitting RDS data). The RDS decoder 7 outputs a predetermined signal upon detection of the subcarrier of 57 KHz, and the decision as to the station is made in response to the said signal. If the decision is of yes, the PI codes are extracted from the RDS data and stored in the data memory 20 (step S7). Then, an RDS lamp lighting signal is outputted to the driving circuit 9, to light the RDS lamp 8B (step S8).

Then, the group type code and the version code BO included in the RDS data are decoded to decide whether or not the RDS data include the list (hereinafter referred to as an AF list) of frequency data of other stations giving the same program signal (step S10). If the decision is of yes, the AF list is read for seven seconds, to store the frequency data of the AF stations in the data memory 20 in order from the lowermost one (step S11). The time required for reading the AF list is minimized if data indicating the number of frequency data of the AF station is received first. However, there is little probability that such data is received first. Therefore, it is difficult to immediately decide the number of the frequency data included in the AF list upon receiving the AF list. Thus, a period required for reading frequency data of 25 AF stations at the maximum is previously set so that the AF list is forcibly read within the period regardless of the number of the frequency data. If the number of frequency data included in the AF list is not more than 24, the same frequency data are repeatedly read.

In this case it is checked whether or not the same data are already stored in the data memory 20. If the data are already stored, the CPU 18 18 does not store the data in the data memory 20 again.

Upon completion of the step S11, the operation step is upgraded to S12. At the step S12, the content of the flag register F1 is decided. If "0" is set in the flag register F1, operation states of the preset keys 12 and 13 and the AF key 16 are supervised at steps S13 and S15. When the preset key 12 or 13 is operated, an AF lamp turn-off signal is outputted to the driving circuit 9 if the AF lamp 8C is lit, and the AF list stored in the data memory 20 is cleared (step 514), and the process is returned to the aforementioned step S5. If the AF key 16 is operated, a decision is made at a step S16 as to whether or not the operation time is at least two seconds. If the decision is of no, transition to the AF search mode is caused. If the decision is of yes, on the other hand, transition to the AF indication mode is caused.

Operation in the AF search mode is now described. In the AF search mode, "1" is set in the flag register F1 at the start (step S17). Then an AF lamp flash signal is outputted to the driving circuit 9, thereby to flash the AF lamp 8C (step S18). Thereafter the operation step is upgraded to S19, to clear the select memory 21. Then, operation states of the AF key 16, the band key 14 and the preset keys 12 and 13 are supervised (steps S20 to S22). If none of the keys is operated, a decision is made as to whether or not the signal strength of the first tuner circuit 2 is in excess of a predetermined value in response to output from the A-D converter 10 (step S23). If the decision is of yes, the timer 22 is cleared at a step S24, while counting operation of the timer 22 is performed at a step S25 if the decision is of no (the timer 22 starts counting operation if the same is cleared, while continues counting operation if the same has already started the operation). Then, the frequency data (excepting the current tuning frequency of the first tuner circuit 2) is read from the AF list stored in the data memory 20 in order from the lowermost one, and transmitted to the second tuner circuit 3 (step S26). Thus, the second tuner circuit 3 is tuned to this frequency. In response to output from the A-D converter 11, a decision is made as to whether or not the signal strength of the second tuner circuit 3 is in excess of a predetermined value (step S27). If the decision is of yes, the select memory 21 stores the data of the current tuning frequency of the second tuner circuit 3 (step S28).

Thereafter the operation through the aforementioned steps S20 to S28 is repeated until all of the frequency data (excepting the data of the current tuning frequency of the first tuner circuit 2) are read from the AF list stored in the data memory 20 (step S29). When the AF list includes 25 frequency data, the processing time for the routine of the steps S20 to S29 is about eight seconds. If the AF key 16 is operated again, this operation is decided at the step S20, and the operation step is upgraded to S30. At the step S30, "0" is set in the flag register F1 and an AF lamp turn-off signal is outputted to the driving circuit 9, thereby to turn off the AF lamp 8C. Upon completion of the step S30, the process is returned to the aforementioned step S13, to terminate the AF search mode. When the band key 15 is operated, this operation is decided at the step S21, and the operation step is upgraded to S31. At the step S31, an RDS lamp turn-off signal and an AF lamp turn-off signal are outputted to the driving circuit 9, thereby to turn off the RDS lamp 8B and the AF lamp 8C. Then the operation step is upgraded to S32, to clear the AF list stored in the data memory 20. Thereafter the process is returned to the aforementioned step S2, to perform processing of the AM mode at the step S3. When the preset key 12 or 13 is operated, this operation is decided at the step S22, whereby the process is returned to the aforementioned step S14.

When it is decided at the step S29 that all of the frequency data are read from the AF list stored in the data memory 20, the operation step is upgraded to S33. At the step S33, a decision is made as to whether or not the select memory 21 stores frequency data of the AF stations. If the decision is of yes, an AF lamp lighting signal is outputted to the driving circuit 9, thereby to light the AF lamp 8C (step S35). Then, "1" is set in a flag register F2 (step S36). If the decision at the step S33 is of no, on the other hand, "0" is set in the flag register F2 (step S34). Upon completion of the step S34 or S36, the operation step is upgraded to S37. At the step S37, a decision is made as to whether or not the timer 22 counts at least 22 seconds.

If the decision at the step S37 is of no, there is no need to change the tuning frequency, and hence the operation step is upgraded to S38. At the step S38, the content of the flag register F2 is decided. If it is decided at the step S38 that "1" is set in the flag register F2, the process is returned to the aforementioned step S19, while the process is returned to the aforementioned step S18 if "0" is set in the flag register F2. That is, the AF lamp 8C is lit if there are frequency data which are at signal strengths exceeding a predetermined value, while the same is flashed if there are no such frequency data.

If the decision at the step S37 is of yes, on the other hand, the tuning frequency of the first tuner circuit 2 must be changed, and hence the operation step is upgraded to S39, to decide the content of the flag register F2. if it is decided at the step S39 that "0" is set in the flag register F2, the process is returned to the aforementioned step S18. That is, if there is no alternative station which is in an excellent receiving state although the signal strength of the first tuner circuit 2 is lowered for a long period of time (22 seconds), this status is informed by flashing the AF lamp 8C. Such status is caused when an automobile carrying the receiver of this embodiment passes through a place of inferior receive conditions such as a tunnel, for example. If it is decided at the step S39 that "1" is set in the flag register F2, on the other hand, the frequency data is read from the select memory 21 in order from lowermost one, and transmitted to the second tuner circuit 3 (step S40). Thus, the second tuner circuit 3 is tuned to the said frequency. Upon completion of the step S40, PI codes extracted from the RDS data are compared with PI codes (those of the station communicating with the first tuner circuit 2) previously stored in the data memory 20 (step S41). If the PI codes coincide with each other, the first and second tuner circuits 2 and 3 receive the same program signal, and hence the tuning frequency data of the second tuner circuit 3 is transmitted to the local oscillation circuit of the first tuner circuit 2 and the driving circuit 9 (step S42). Thus, the first tuner circuit 2 is tuned to the said frequency, which in turn is indicated on the frequency indicator 8A. Thereafter the timer 22 is cleared (step S43), and the process is returned to the aforementioned step S18. If the PI codes are not coincident with each other, on the other hand, the frequency data corresponding to the tuning frequency in the second tuner circuit 3 is deleted from the select memory 21 (step S44). Thereafter a decision is made as to whether or not the select memory 21 stores frequency data. If the decision at the step S45 is of yes, the process is returned to the aforementioned step S40, and the operation through the steps S40, S41, S44 and S45 is repeated until coincidence of the PI codes is detected. When all of remaining frequency data are deleted from the select memory 21 upon repetition of the steps S40, S41, S44 and S45, the process is returned to the aforementioned step S18.

Description is now made on operation in the AF indication mode performed when it is decided at the aforementioned step S16 that the operation time of the AF key 16 is at least two seconds. First, "1" is set in the flag register F1 at a step S46. Then, the operation step is upgraded to S47 and an AF lamp lighting signal is outputted to the driving circuit 9, thereby to light the AF lamp 8C. Then the operation step is upgraded to S48, to read the frequency data (excepting the tuning frequency of the first tuner circuit 2) from the data memory 20 in order from the lowermost one, and transmit the same to the driving circuit 9. Thus, the said frequency is indicated on the frequency indicator 8A. Then the operation step is upgraded to S49, to start the timer 22 from an initial state. Then, operation states of the preset keys 12 and 13, the band key 15, the AF key 16 and the memory key 14 are supervised (steps S50 to S53). Indication of the frequency on the frequency indicator 8A and supervision of the operation states of the respective keys are performed until the timer 22 counts two seconds (step S54). If it is decided at the step S54 that the timer 22 counts two seconds, the operation step is upgraded to S55, at which a decision is made as to whether or not all of the frequency data are read from the AF list stored in the data memory 20. If the AF list includes unread frequency data, the operation step is returned to S48, to indicate subsequent frequency data and to supervise the operation states of the respective keys (steps S48 to S54).

If the preset key 12 or 13 is operated, this operation is decided at the step S50 and the process is returned to the aforementioned step S14. If the band key 15 is operated, this operation is decided at the step S51 to turn off the RDS lamp 8B and the AF lamp 8C as well as to clear the AF list stored in the data memory (steps S56 and S57), and the process is returned to the aforementioned step S2. If the AF key 16 is again operated, this operation is decided at the step S52, and the operation step is upgraded to S58. Also at the step S58, the AF lamp 8C is turned off. Then, "0" is set in the flag register F1 at a step S59. Thereafter the data of the current tuning frequency in the first tuner,circuit 2 is transmitted to the driving circuit 9 at a step S60, and the said frequency is again indicated on the frequency indicator 8A. Upon completion of the step S60, the process is returned to the aforementioned step S13. If the preset key 12 or 13 is operated after operation of the memory key 14, this operation is decided at the step S53, and the operation step is upgraded to S61. At the step S61, the data of the current tuning frequency in the second tuner circuit 3 is stored in a storage area of the data memory 20 corresponding to the currently operated preset key. Thereafter the operation step is returned to S54. When all of the frequency data included in the AF list stored in the data memory 20 are completely indicated, a decision is made on this at the step S55, and the operation step is upgraded to S62. At the step S62, the data of the current tuning frequency in the first tuner circuit 2 is transmitted to the driving circuit 9, and this frequency is indicated on the frequency indicator 8A. Thereafter the process is returned to the aforementioned step S12, for transition to the AF search mode.

According to the first embodiment of the present invention as hereinabove described, when the signal strength of the first tuner circuit 2 is continuously lowered below a predetermined value for at least 22 seconds and it is decided at the step S37 that the tuning frequency of the first tuner circuit 2 must be changed, the said tuning frequency can be quickly changed through the frequency data searched from the AF list and already stored in the select memory 21 as frequency data which are at signal strengths exceeding the predetermined value.

When all of the frequency data included in the AF list are at signal strengths which are lower than the predetermined value, the AF lamp 8C is flashed to inform the user of the fact that the radio receiver is normally operated even if the same is in an inferior receiving state. Consequently, the user is released from anxiety as to whether or not the AF function is in a normal state, i.e., whether or not the radio receiver is normally operated when the radio receiver enters an inferior receiving state.

Further, either the AF search mode (steps S17 to S45) or the AF indication mode (steps S46 to S62) is executed in response to the operation time of the AF key 16. Thus, these operation modes can be switched through a smaller number of key. In addition, the key operation is simplified.

Once transition to the AF search mode or the AF indication mode is caused through the AF key 16, the process is automatically returned to the AF search mode even if the band or frequency is changed during each mode. This is because "0" is set in the flag register F1 in transition to the AF search mode or the Af indication mode and this setting is decided at the step S12 after completion of the operation for changing the band or the tuning frequency, so that the process is returned to the routine of the AF search mode through no operation of the AF key 16. Thus, it is not necessary to operate the AF key 16 whenever the band or the tuning frequency is changed, and hence no complicated key operation is required. In order to cause transition from the AF search mode to another mode, the AF key 16 may be operated again (steps S20 and S30).

According to the first embodiment of the present invention, further, the count of the timer 22 is detected at the step S37 whenever all of the frequency data are completely searched from the AF list at the steps S20 to S29, whereby changeability of the tuning frequency to that of another station is increased.

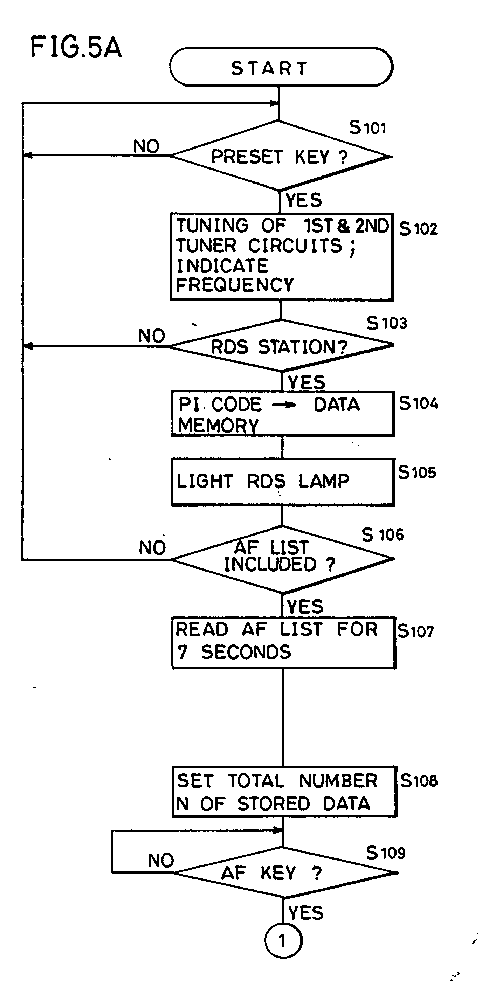

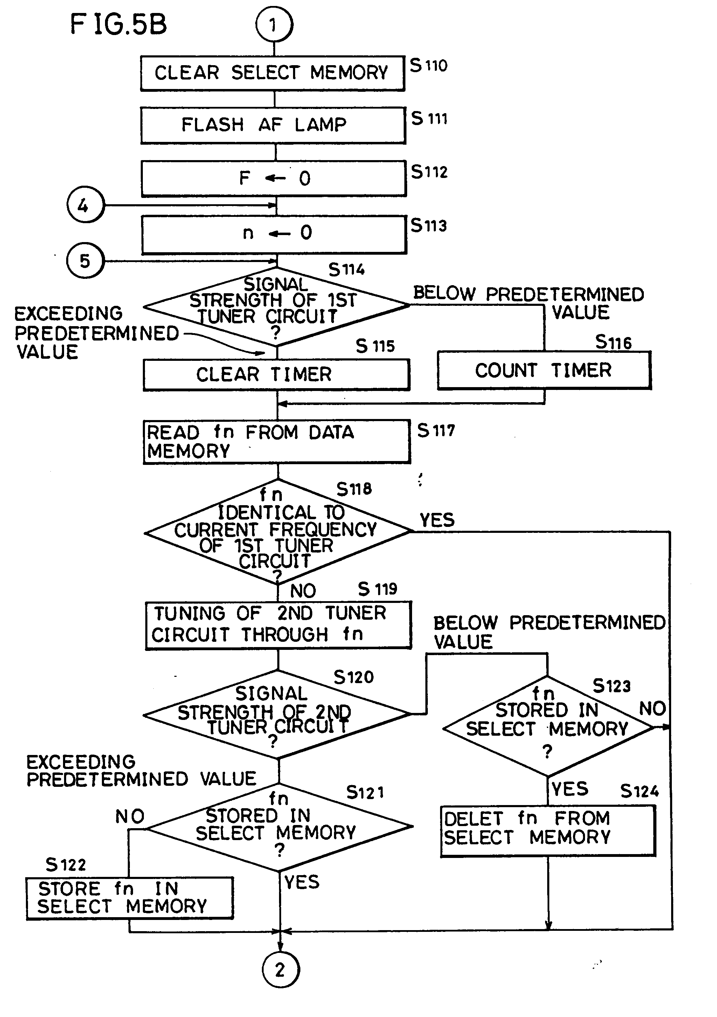

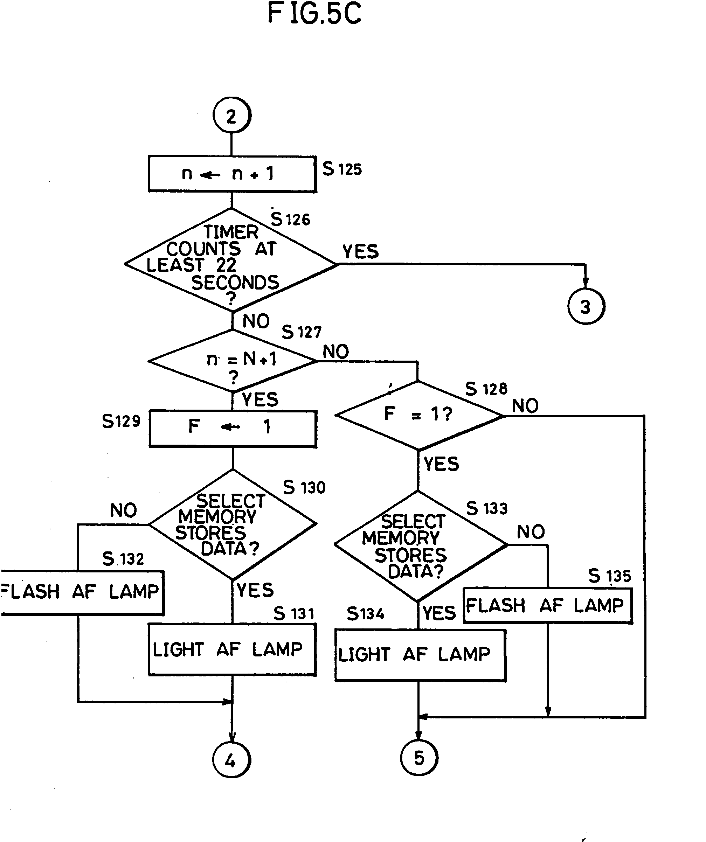

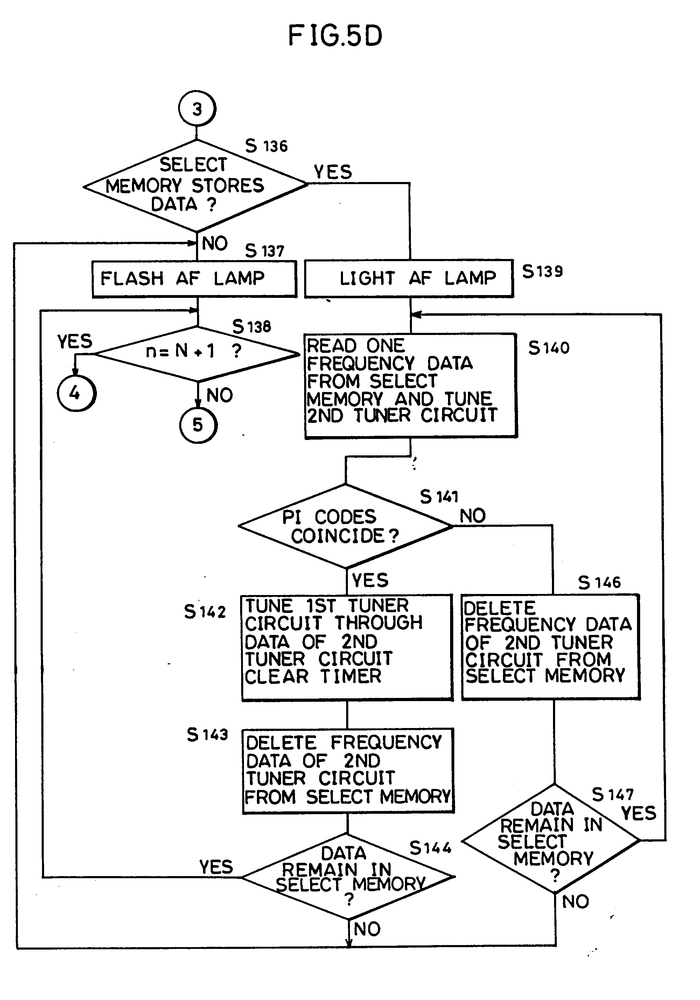

However, if the count time of the timer 22 after execution of the steps S20 to S29 is 21 seconds, frequency data are again searched at the steps S20 to S29, and hence change of the tuning frequency is delayed by the processing time therefor (about eight seconds at the maximum). In order to solve this problem, the CPU 18 may supervise the count time of the timer 22 during the search for the frequency data to change the tuning frequency in response to frequency data theretofore searched even if the search for the frequency data is not yet completed. Figs. 5A to 5D show another embodiment for implementing such operation.

### Second Embodiment

Figs. 5A to 5D are flow charts for illustrating operation of a second embodiment of the present invention. A hard circuit employed in the second embodiment is similar to that of the first embodiment (see Fig. 2). Namely, difference simply resides in that the operation program written in the program memory 19 is changed to that shown in Figs. 5A to 5D. With reference to Figs. 5A to 5D, the operation of the second embodiment is now described.

Upon power supply, it is decided at a step S101 that the preset key 12 or 13 is operated. At a step S102, frequency data is read from a storage area of the data memory 20 corresponding to the operated preset key 12 or 13, and transmitted to the respective local oscillation circuits of the first and second tuner circuits 2 and 3 and the driving circuit 9. Thus, the first and second tuner circuits 2 and 3 are tuned to the said frequency, which in turn is indicated on the frequency indicator 8A. Thereafter a decision is made at a step S103 as to whether or not the station currently communicating with the second tuner circuit 3 is an RDS station. If the decision is of no, the operation step is returned to S101, while the operation step is upgraded to S104 if the decision is of yes. At the step S104, PI codes extracted from RDS data by the RDS decoder 7 are stored in the data memory 20. Thereafter an RDS lamp lighting signal is outputted to the driving circuit 9 at a step S105, thereby to light the RDS lamp 8B. Thereafter a decision is made at the step S106 as to whether or not the RDS data include an AF list. If the decision is of no, the operation step is returned to S101. if the decision is of yes, on the other hand, the AF list is read for seven seconds at a step S107, and stored in the data memory 20. Thereafter the frequency data stored in the data memory 20 are counted and the total number thereof is set as N at a step S108.

When the AF key 16 is operated, this operation is decided at a step S109, and the operation step is upgraded to S110. At the step S110, the select memory 21 is cleared. Thereafter the AF lamp 8C is flashed and "0" is set in a flag register F (provided in the CPU 18, for example) and "1" is set in a counter n (provided in the CPU 18, similarly to the flag register F) (steps S111 to S113). Thereafter a decision is made at a step S114 as to whether or not the signal strength of the first tuner circuit 2 is in excess of a predetermined value. If the decision is of yes, the timer 22 is cleared at a step S115. If the decision is of no, the timer 22 performs counting operation at a step S116.

After the step S115 or S116, frequency data fn is read from the AF list in an area of the data memory 20 corresponding to the count value of the counter n at a step S117. Thereafter a decision is made at a step S118 as to whether or not the current tuning frequency of the first tuner circuit 2 is identical to the frequency data fn. If the decision is of yes, the following steps S119 to S124 are not carried out but the operation step is directly upgraded to S125. If the decision is of no, on the other hand, the frequency data fn is transmitted to the local oscillation circuit of the second tuner circuit 3 at the step S119, whereby the second tuner circuit 3 is tuned to this frequency. Thereafter a decision is made at a step S120 as to whether or not the signal strength of the second tuner circuit 3 is in excess of a predetermined value. If the decision is of yes, a decision is made at the step S121 as to whether or not the frequency data fn is already stored in the select memory 21. if the decision is of no, the frequency data fn is stored in the select memory 21 at the step S122. Thereafter the operation step is upgraded to S125. If the decision at the step S121 is of yes, on the other hand, the operation step is upgraded to S125. If it is decided at the step S120 that the signal strength of the second tuner circuit 3 is below the predetermined value, a decision is made at the step S123 as to whether or not the frequency data fn is already stored in the select memory 21. If the decision is of yes, the frequency data fn is deleted from the select memory 21 at the step S124, and the operation step is upgraded to S125. If the decision is of no, on the other hand, the operation step is directly upgraded to S125. At the step S125, the counter n is incremented by 1. Thereafter a decision is made at a step S126 as to whether or not the timer 22 counts at least 22 seconds. If the decision is of no, a decision is made at a step S127 as to whether or not the count value of the counter n is N + 1, i.e., whether or not the count value exceeds the total number N of the frequency data stored in the data memory 20. If the decision is of no, a decision is made at a step S128 as to whether or not "1" is set in the flag register F. Since "0" is set in the flag register F until first search is completed through the AF list stored in the data memory 20 for the entire frequency data included therein, the process is returned to the aforementioned step S114. That is, the AF lamp 8C is continuously flashed as a preparation stage until the first search is completed, whether the select memory 21 stores the frequency data or not. This preparation stage is for about eight seconds, and no request for changing the tuning frequency in the first tuner circuit 2 is generated during this stage, since the timer 22 counts 22 seconds.

When the operation through the aforementioned steps S114 to S128 is repeatedly executed and the search for the entire frequency data included in the AF list stored in the data memory 20 is completed, the count value of the counter n reaches N + 1 and this is decided at a step S127, whereby the operation step is upgraded to S129. At the step S129, "1" is set in the flag register F. Thereafter a decision is made at a step S130 as to whether or not the select memory 21 stores frequency data. In other words, a decision is made as to whether or not frequency data, which are at signal strengths exceeding a predetermined value, are found as the result of the search in the AF list. If the decision is of yes, the AF lamp 8C is lit at a step S131. Thereafter the operation step is returned to S113. If the decision at the step S130 is of no, on the other hand, the flashing state of the AF lamp 8C is retained at a step S132. Thereafter the operation step is returned to S113. Thus, when the first search in the AF list is completed, the indication state of the AF lamp 8C is controlled in response to the content of the select memory 20. That is, when the AF lamp 8C is lit, the user can recognize that there are changeable frequency data.

When the receiver enters a cycle for second search upon completion of the first search in the AF list, this time a decision is made as to whether or not the select memory 21 stores frequency data even if the search is not yet completed (steps S128 and S133). If the decision is of yes, the AC lamp 8C is lit at a step S134. If the select memory 21 stores no frequency data, the AF lamp 8C is flashed at a step S135. After the step S134 or S135, the operation step is returned to S114.

Description is now made on operation performed when it is decided at the aforementioned step S126 that the timer 22 counts at least 22 seconds, i.e., that the tuning frequency of the first tuner circuit 2 must be changed. At a step S136, a decision is made as to whether or not the select memory 21 stores frequency data. If the decision is of no, the AF lamp 8C is flashed to inform this at a step S137. Thereafter a decision is made at a step S138 as to whether or not the counter n counts N + 1. That is, a decision is made as to whether or not a request for changing the tuning frequency is generated during the search in the AF list. If the counter n counts N + 1, the process is returned to the aforementioned step S113. That is, "1" is set in the counter n and the AF list is again searched. If the count value of the counter n is not N + 1, on the other hand, the operation step is returned to S114. In this case, the search in the AF list is re-started without initializing the counter n.

If the decision at the step S136 is of yes, the AF lamp 8C is lit at a step S139. Thereafter the lowermost frequency data is read from the select memory 21 at a step S140, to be transmitted to the local oscillation circuit of the second tuner circuit 3. Thus, the tuning frequency of the second tuner circuit 3 is changed to the said frequency. Thereafter a decision is made at a step S141 as to whether or not PI codes included in RDS data of receiving output of the second tuner circuit 3 coincide with those of the program signal received in the first tuner circuit 2 previously stored in the data memory 20. In other words, a decision is made as to whether or not the second tuner circuit 3 receives the same program signal as the first tuner circuit 2. If the decision is of yes, the tuning frequency of the second tuner circuit 3 is transmitted to the local oscillation circuit of the first tuner circuit 2 and the timer 22 is cleared at a step S142. Thus, the first tuner circuit 3 is changed to the same tuning frequency as the second tuner circuit 3. Thereafter the tuning frequency of the second tuner circuit 3 is deleted from the select memory 21 at a step S143. Then, a decision is made at a step S144 as to whether or not frequency data still remain in the select memory 21. If the decision is of yes, the operation step is upgraded to S138. If the decision is of no, on the other hand, the operation step is upgraded to S137, to flash the AF lamp 8C. If no coincidence of the PI codes is decided at the step S141, the tuning frequency of the second tuner circuit 3 is deleted from the select memory 21 at a step S146. Thereafter a decision is made at a step S147 as to whether or not frequency data still remain in the select memory 21. If the decision is of yes, the operation step is returned to S140, and subsequent frequency data is read from the select memory 21. If the decision at the step S147 is of no, on the other hand, the operation step is returned to the step S137.

In the second embodiment of the present invention as hereinabove described, a decision is made as to whether or not a request for changing the tuning frequency is generated even if the search in the AF list stored in the memory 20 is not yet completed. Although a delay of eight seconds at the maximum is caused upon a request for changing the tuning frequency in the aforementioned first embodiment, no such delay is caused in the second embodiment, whereby the request for changing the tuning frequency can be quickly satisfied.

It is to be noted that the flow charts of the second embodiment show only essential parts. In practice, operation states of the band key, the preset keys, the memory key and the AF key are supervised at timing similar to that in the first embodiment. This also applies to the following third to sixth embodiments.

### Third Embodiment

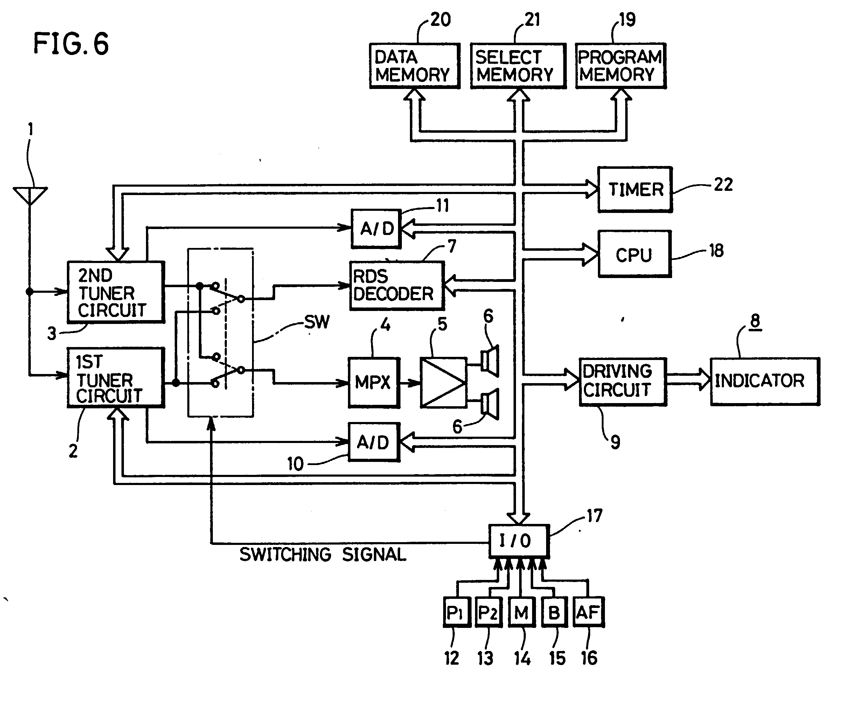

Fig. 6 is a block diagram showing the structure of a radio receiver according to a third embodiment of the present invention. Referring to Fig. 6, a switching circuit SW is provided between first and second tuner circuits 2 and 3 and a multiplexer 4 and an RDS decoder 7. This switching circuit SW performs switching operation in response to a switching signal supplied from a CPU 18 through an I/O port 17 and a data bus. In a first mode, the switching circuit SW connects the first tuner circuit 2 with the multiplexer 4 and the second tuner circuit 3 with the RDS decoder 7 respectively, as shown by solid lines in Fig. 6. In a second mode, the switching circuit SW connects the first tuner circuit 2 with the RDS decoder 7 and the second tuner circuit 3 with the multiplexer respectively, as shown by dotted lines in Fig. 6. Other structure of this embodiment is similar to that of the first embodiment shown in Fig. 2, and hence corresponding parts are indicated by the same reference numerals, to omit redundant description.

Operation of the third embodiment is basically identical to that of the first embodiment, except for the following points:

When the switching circuit SW is in the connection state shown by the solid lines in the aforementioned first mode, the first tuner circuit 2 receives an ordinary program signal and the second tuner circuit 3 searches for frequency data. When the signal strength of the first tuner circuit 2 is continuously lowered below a predetermined value for 22 seconds, frequency data read from a select memory 21 is supplied to the second tuner circuit 3. If PI codes of the station communicating with the first tuner circuit 2 coincide with those of the station communicating with the second tuner circuit 3, the switching circuit SW is switched by a switching signal into the state shown by the dotted lines, to cause transition to the second mode. In the second mode, the first tuner circuit 2 searches for frequency data and the second tuner circuit 3 receives the ordinary program signal. Thereafter the first and second modes are alternately switched whenever the switching signal is supplied to switching circuit SW from CPU18.

In the aforementioned first embodiment, the second tuner circuit 3 is tuned through the frequency data read from the select memory 21, and thereafter the tuning frequency data of the second tuner circuit 3 is transmitted to the first tuner circuit 2 upon coincidence of the PI codes, thereby to change the tuning frequency of the first tuner circuit 2. Thus, the time for tuning the first tuner circuit 2 causes a loss in the operation for changing the frequency. In the third embodiment, on the other hand, only the time for switching the switching circuit SW causes a loss, and hence the tuning frequency can be quickly changed as compared with the first embodiment.

The third embodiment is also applicable to the second embodiment, as a matter of course.

### Fourth Embodiment

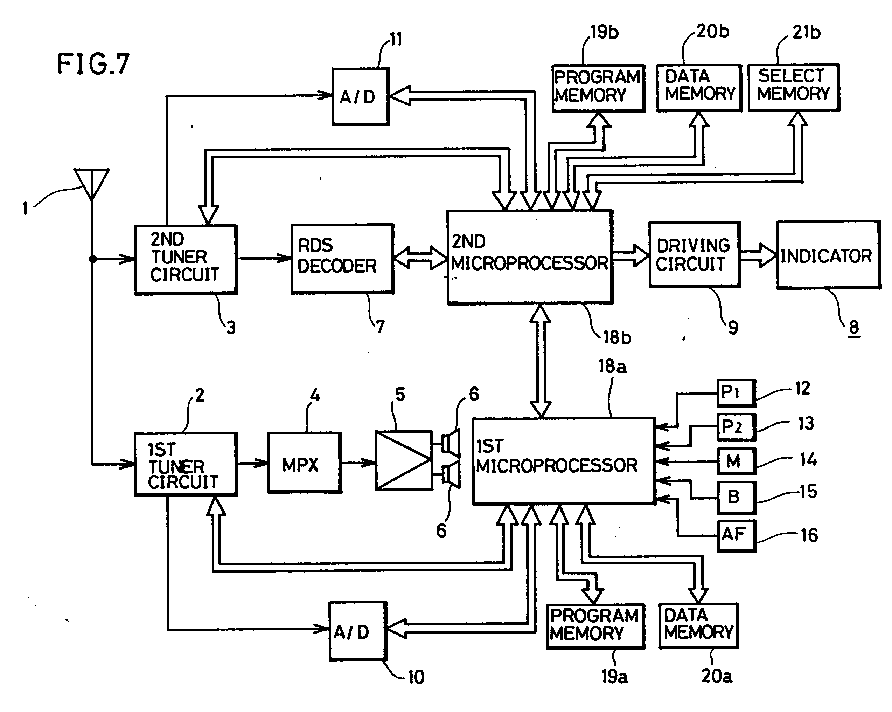

In each of the aforementioned first to third embodiments, a single CPU 18 is adapted to process the RDS data and to receive the ordinary program signal. Therefore, a high-priced microprocessor having high throughput is required for the CPU 18. Thus, it is preferable to employ two microprocessors in order to share the processing and transfer the data with each other. Fig. 7 shows a fourth embodiment of the present invention.

Referring to Fig. 7, this embodiment is provided with a first microprocessor 18a and a second microprocessor 18b. The first microprocessor 18a is adapted to receive an ordinary program signal along a program written in a program memory 19a, which is formed by a ROM, as follows: The first microprocessor 18a performs processing such as supervision of operation states of preset keys 12 and 13, a memory key 14, a band key 15 and an AF key 16, transfer of data with a data memory 20a, transmission of frequency data to the local oscillation circuit of a first tuner circuit 2, transfer of data with the second microprocessor 18b, and the like. Further, the first microprocessor 18a detects the signal strength of the first tuner circuit 2 in response to output from an A-D converter 10, to output a change command signal for the tuning frequency of the first tuner circuit 2 to the second microprocessor 18b when the signal strength is continuously lowered below a predetermined value for at least 22 seconds.

The second microprocessor 18b is adapted to process RDS data along a program written in the program memory 19b formed by a ROM as follows: The second microprocessor 18b performs processing such as data transfer with the first microprocessor 18a, processing of RDS data, data transfer with a data memory 20b and a select memory 21b, transmission of frequency data to the local oscillation circuit of a second tuner circuit 3 and a driving circuit 9, and the like. The data memory 20b has areas for storing 25 frequency data, at the maximum, included in an AF list and areas for storing PS codes and PI codes, similarly to the data memory 20 shown in Fig. 2. The select memory 21b stores frequency data which are at signal strengths exceeding a predetermined value within those stored in the data memory 20b, similarly to the select memory 21 shown in Fig. 2.

Other structure of the embodiment shown in Fig. 7 is similar to that of the first embodiment shown in Fig. 2, and hence corresponding parts are indicated by the same reference numerals, to omit redundant description.

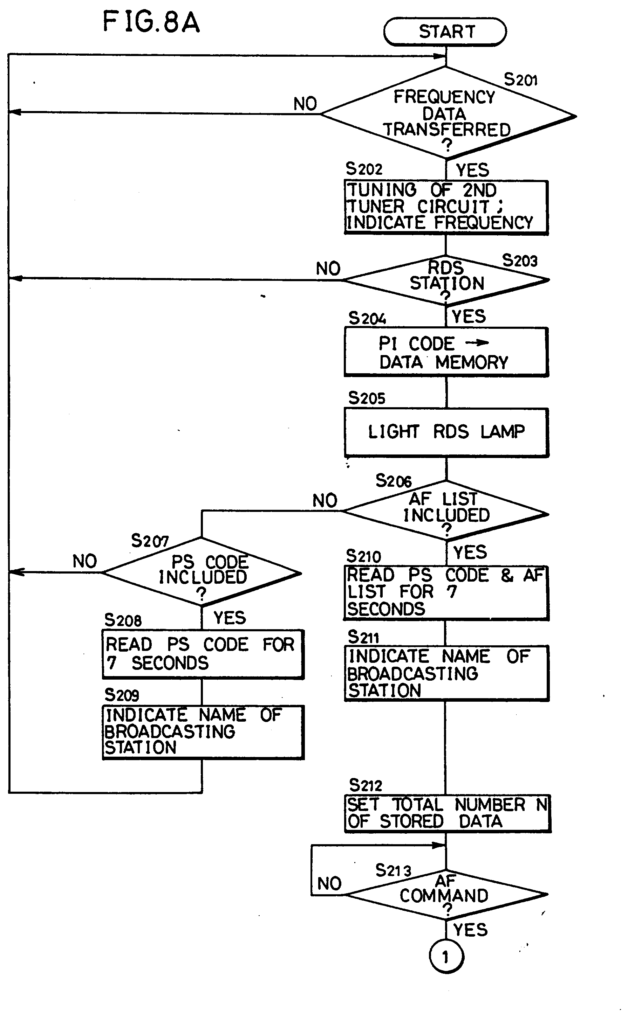

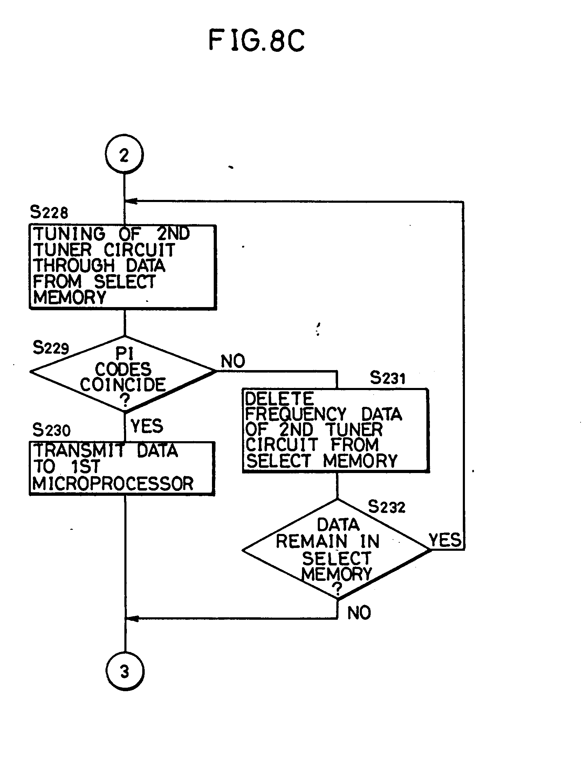

The operation of the fourth embodiment is now described with reference to Figs. 8A to 8C. Figs. 8A to 8C are flow charts showing the operation of the second microprocessor 18b. This operation is written in the program memory 19b as program information.

Upon power supply, the preset key 12 or 13 is operated in the FM band, and the first microprocessor 18a reads frequency data corresponding to the operated preset key from the data memory 20a and supplies the same to the local oscillation circuit of the first tuner circuit 2 and the second microprocessor 18b. The second microprocessor 18b decides that the frequency data is transferred from the first microprocessor 18a at a step S201, to perform the following operation: At a step S202, the frequency data received from the first microprocessor 18a is supplied to the local oscillation circuit of the second tuner circuit 3 and the driving circuit 9. Thus, the second tuner circuit 3 is tuned to the said frequency, which in turn is indicated on a frequency indicator 8A. Then, a decision is made at a step S203 as to whether or not a station communicating with the second tuner circuit 3 is an RDS station. If the decision is of yes, PI codes currently extracted by the RDS decoder 7 are stored in the data memory 20b at a step S204. Thereafter an RDS lamp lighting signal is outputted to the driving circuit 9 at a step S205, to light an RDS lamp 8B.

At a step S206, a decision is made as to whether or not RDS data outputted from the RDS decoder 7 include an AF list. If the decision is of no, a decision is made at a step S207 as to whether or not the RDS data include PS codes. If the decision is of yes, the PS codes are read for seven seconds at a step S208, and stored in the data memory 20b. Thereafter the name of the broadcasting station is indicated on the frequency indicator 8A in response to the stored PS codes at a step S209. Thereafter the operation step is returned to S201. If it is decided that the RDS data include an AF list at the aforementioned step S206, on the other hand, the PS codes and the AF list are read for seven seconds at a step S210, and stored in the data memory 20b. It is noted that RDS data including an AF list necessarily include PS codes. Thereafter the name of the broadcasting station is indicated on the frequency indicator 8A at a step S211 in response to the stored PS codes. Thereafter the total number of frequency data included in the AF list currently stored in the data memory 20b is set as N at a step S212.

When the AF key 16 is operated in this state, the first microprocessor 18a outputs an AF command signal to the second microprocessor 18b. The second microprocessor 18b decides that the AF command signal is received from the first microprocessor 18a (step S213), to flash the AF lamp 8C at a step S214. Thereafter the select memory 21b is cleared and "1" is set in a counter n (steps S215 and S216). Thereafter a decision is made at a step S217 as to whether or not return data concerning receiving of frequency data is transferred from the first microprocessor 18a. If the decision is of no, frequency data which is at a signal strength exceeding a predetermined value is searched from those stored in the data memory 20b, and stored in the select memory 21b (steps S217 to S224). That is, frequency data fn corresponding to the count value of the counter n is read from the data memory 20b and the second tuner circuit 3 is tuned through the read frequency data fn, so that the frequency data fn is stored in the select memory 21b if the signal strength of the second tuner circuit 3 is in excess of the predetermined value. Thereafter the value of the counter n is updated one by one and the aforementioned operation is repeated until the value reaches N. If the frequency data fn read from the data memory 20b coincides with the tuning frequency of the first tuner circuit 2, no judgement is made on the signal strength of the second tuner circuit 3 (step S219).

When it is decided at a step S223 that the value of the counter n reaches N, i.e., that search in the data memory 20b is completed for all frequency data, a decision is made at a step S225 as to whether or not the select memory 21b stores frequency data. If the decision is of no, the operation step is returned to S214, to repeat the search for the frequency data which is at a signal strength exceeding the predetermined value. If the select memory 21b stores frequency data, on the other hand, the AF lamp 8C is lit at a step S226 to indicate presence of changeable frequency data. Thereafter a decision is made at a step S227 as to whether or not a change command for the tuning frequency is generated from the first microprocessor 18a. If the decision is of no, the second microprocessor 18b again repeats the operation through the steps S215 to S227.

The first microprocessor 18a detects the fact that the signal strength of the first tuner circuit 2 is continuously lowered below a predetermined value for at least 22 seconds, to output a change command for the tuning frequency to the second microprocessor 18b. In response to the change command for the tuning frequency from the first microprocessor 18a, the second microprocessor 18b performs the following operation: At a step S228, the lowermost frequency data is read from the select memory 21b and transmitted to the local oscillation circuit of the second tuner circuit 3. Thus, the second tuner circuit 3 is tuned to the said frequency. Thereafter PI codes currently extracted by the RDS decoder 7 are compared with PI codes (those of the station communicating with the first tuner circuit 2) previously stored in the data memory 20b at a step S229. If the PI codes coincide with each other, i.e., if the first and second tuner circuits 2 and 3 receive the same program signal, the data of the tuning frequency in the second tuner circuit 3 is transmitted to the first microprocessor 18a at a step S230. If the PI codes are not coincident, on the other hand, the frequency data supplied to the second tuner circuit 3 is deleted from the select memory 21b at a step S231. Thereafter a decision is made at a step S232 as to whether or not the select memory 21 stores frequency data. If the decision is of yes, the operation step is returned to S228, and subsequent frequency data is read from the select memory 21b. If the select memory 21b stores no frequency data, on the other hand, the process is returned to the aforementioned step S214.

After the step S230, the second microprocessor 18b supervises transfer of return data (indicating that the first tuner circuit 2 is tuned through the frequency data received from the second microprocessor 18b) from the first microprocessor 18a at a step S217 to search for frequency data which is at a signal strength exceeding a predetermined value until the said data is transferred (steps S214 to S227).

Then, the first microprocessor 18a tunes the first tuner circuit 2 through the frequency data received from the second microprocessor 18b at the aforementioned step S230. When the first tuner circuit 2 is thus tuned to the frequency, the first microprocessor 18a transmits data indicating the fact that the first tuner circuit 2 is tuned to the second microprocessor 18b. The second microprocessor 18b decides that the aforementioned data is transferred from the first microprocessor 18a at the step S217, to interrupt the search for the frequency data and performs the following operation: At a step S233, the frequency data received in the first tuner circuit 2 is supplied to the local oscillation circuit of the second tuner circuit 3 and the driving circuit 9. Thus, the second tuner circuit 3 is tuned to the said frequency, which in turn is indicated on the frequency indicator 8A. Thereafter a decision is made at a step S234 as to whether or not RDS data extracted by the RDS decoder 7 include PS codes. If the decision is of yes, the PS codes are read for seven seconds at a step S235, and stored in the data memory 20b. Thereafter the name of the broadcasting station is indicated on the frequency indicator 8A in response to the stored PS codes at a step S236. Then the operation step is returned to S218, to re-start the interrupted search for the frequency data.

In the fourth embodiment as hereinabove described, the second microprocessor 18b also searches for frequency data after transferring the frequency data for change to the first microprocessor 18a, until the first microprocessor 18a transfers the data indicating that the first tuner circuit 2 is tuned through the frequency data to the second microprocessor 18b. Therefore, a response time in data transfer between the first and second microprocessors 18a and 18b can be effectively used with no waste.

### Fifth Embodiment

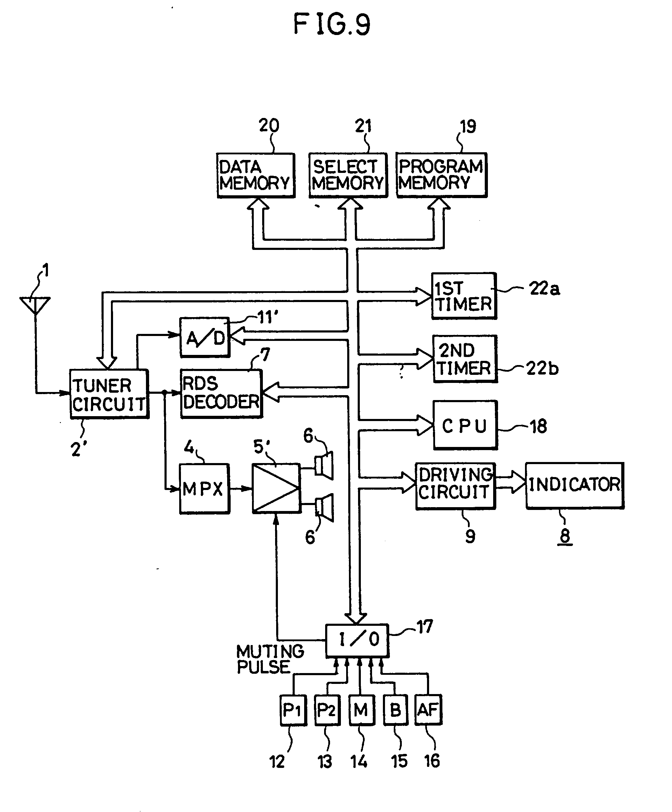

Fig. 9 is a block diagram showing the structure of a fifth embodiment of the present invention. The fifth embodiment includes only a single tuner circuit 2' as receiving means. Receiving output of the tuner circuit 2' is supplied to a multiplexer 4, as well as to an RDS decoder 7. An A-D converter 11' detects the signal strength of the tuner circuit 2'. The tuner circuit 2' is alternately switched between a first mode for receiving an ordinary program signal and a second mode for searching for frequency data stored in an AF list. A first timer 22a is adapted to measure the time for switching the first and second modes. The first timer 22a is connected to a CPU 18 through a data bus. A second timer 22b is adapted to measure the time for detecting the fact that the signal strength of the tuner circuit 2' is continuously lowered below a predetermined value for at least 22 seconds, similarly to the timer 22 shown in Fig. 2. The second timer 22b is also connected to the CPU 18 through the data bus. The CPU 18 supplies muting pulses to an amplifier 5' through an I/O port 17. Other structure of this embodiment is similar to that of the first embodiment shown in Fig. 2, and corresponding parts are indicated by the same reference numerals, to omit redundant description.

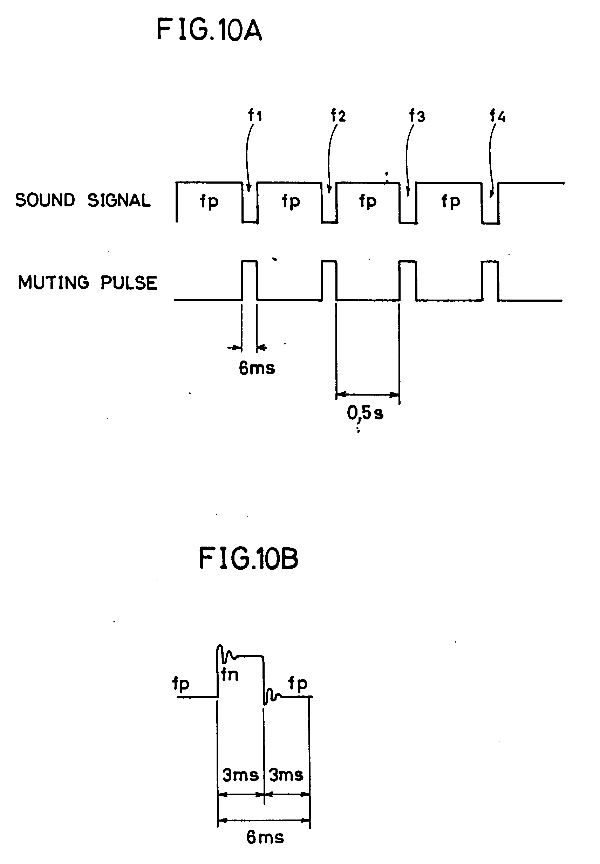

Before description of the fifth embodiment is made in detail, its operation is schematically described. In the fifth embodiment, receiving of the ordinary program signal in the tuner circuit 2' is constantly interrupted and frequency data fn (n + 1, 2, ...) is read from an AF list stored in a data memory 20 during such interruption, to tune the tuner circuit 2' through the frequency data fn. The signal strength of the tuner circuit 2' is detected, and if the same is in excess of a predetermined value, the current frequency data is stored in a select memory 21. Fig. 10A shows timing for switching the receiving modes in the tuner circuit 2'. Whenever the ordinary program signal is received through frequency data fp selected by a preset key 12 or 13 by 0.5 s, reproduction of the program signal from a speaker 6 is interrupted for 6 ms by a muting pulse. As shown in Fig. 10B, the frequency data fn (n = 1, 2, ...) read from the data memory 20 is supplied to the tuner circuit 2' in a first half (3 ms) of the interruption period of 6 ms, whereby the tuner circuit 2' is tuned to the said frequency. In a second half (3 ms) of the interruption period, the original frequency data fp is again supplied to the tuner circuit 2'. The second half (3 ms) is also muted since noise is caused in the receiving output of the tuner circuit 2' when the tuning frequency is changed, as shown in Fig. 10B.

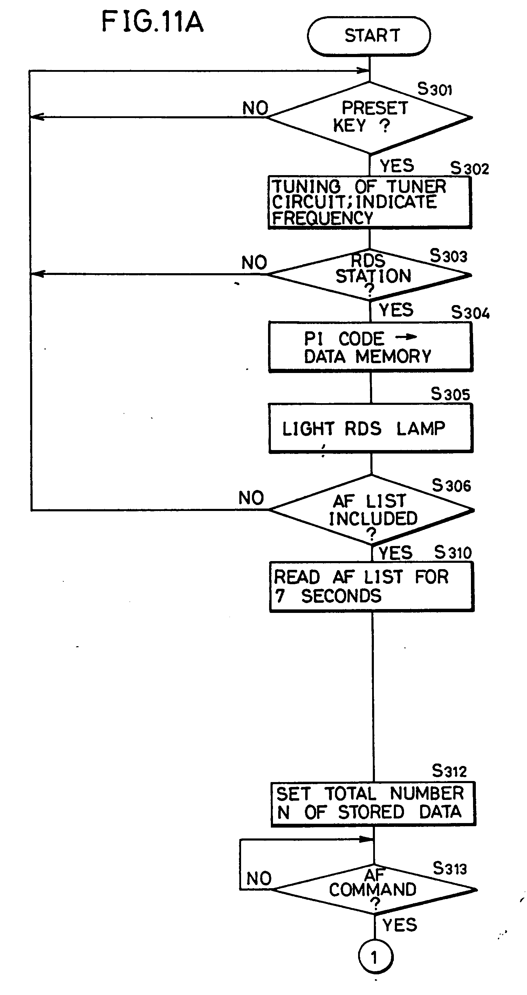

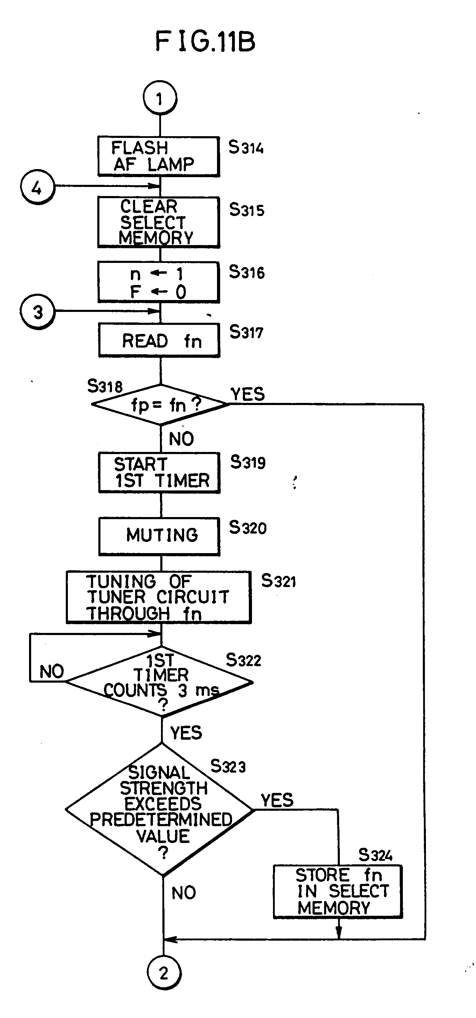

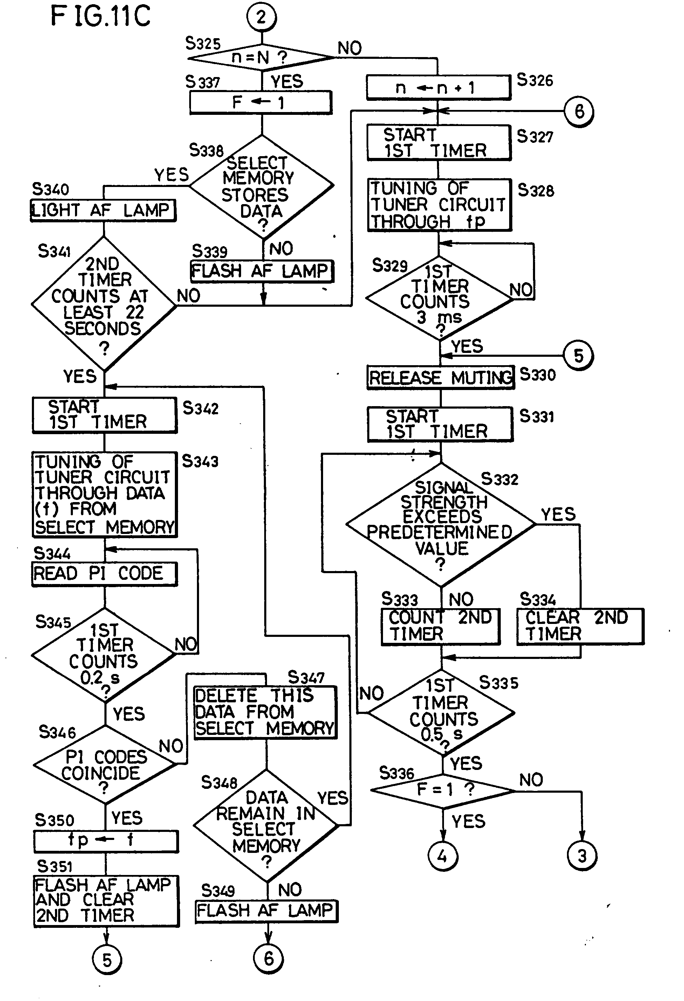

The operation of the fifth embodiment is now described with reference to Figs. 11A to 11C.

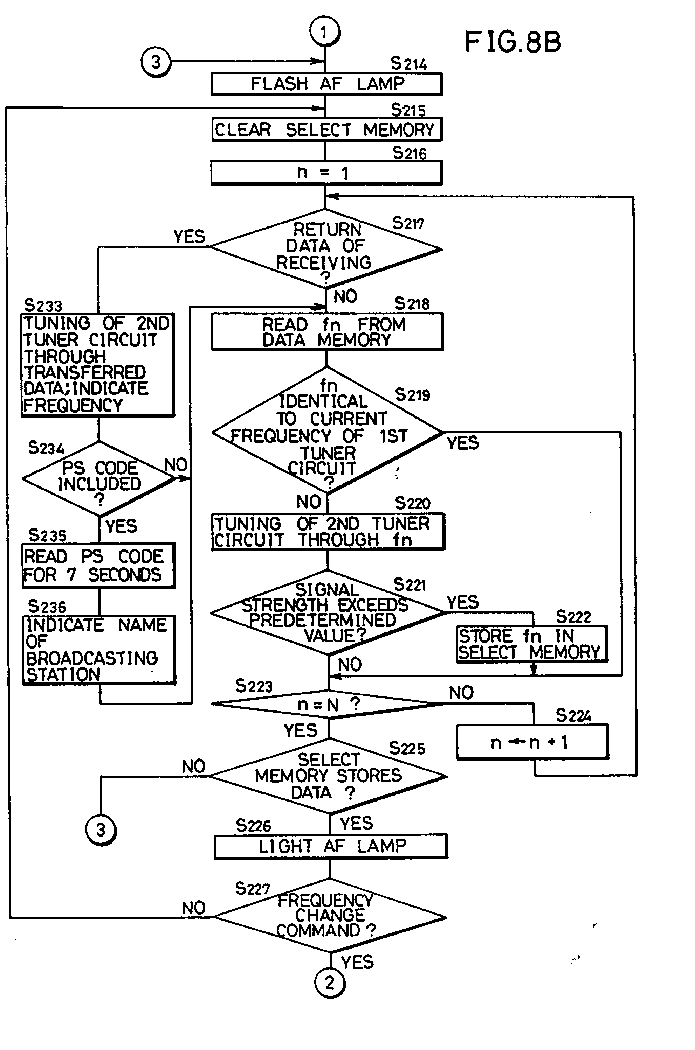

Upon power supply, a decision is made at a step S301 as to whether or not the preset key 12 or 13 is operated. If the decision is of yes, frequency data fp corresponding to the operated preset key is read from the data memory 20 at a step S302, and supplied to a local oscillation circuit of the tuner circuit 2' and a driving circuit 9. Thus, the tuner circuit 2' is tuned to the said frequency, which in turn is indicated on a frequency indicator 8A. Thereafter operation through the steps S303 to S315 is performed substantially similarly to that through the steps S203 to S215 in the fourth embodiment as shown in Figs. 8A and 8B. That is, a decision is made as to whether or not the station communicating with the tuner circuit 2' is an RDS station, and if the decision is of yes, PI codes and an AF list are stored in the data memory 20. Then the AF key 16 is operated to flash an AF lamp 8C, and a select memory 21 is cleared.

The fifth embodiment is provided with no operation steps corresponding to the steps S207 to S209 and S211 of the fourth embodiment.

Thereafter "1" is set in a counter n and "0" is set in a flag register F at a step S316. Then frequency data fn is read from a storage area of the data memory 20 corresponding to the counter n at a step S317. Thereafter a decision is made at a step S318 as to whether or not the frequency data fp coincides with the frequency data fn. The frequency data fp is selected through operation of the preset key 12 or 13. If the frequency data fp and fn are not coincident with each other, a first timer 22a is started from a cleared state at a step S319. Thus, counting of the first half (3 ms) of the aforementioned interruption period is started. Thereafter a muting pulse is supplied to the amplifier 5' at a step S320. Thus, the amplifier 5' mutes an inputted sound signal. Thereafter the frequency data fn read from the data memory 20 is supplied to the local oscillation circuit of the tuner circuit 2' at a step S321. Thus, the tuner circuit 2' is tuned to the said frequency. Thereafter a decision is made at a step S322 as to whether or not the count time of the first timer 22a reaches 3 ms. If the decision is of yes, a decision is made at a step S323 as to whether or not the signal strength of the tuner circuit 2' is in excess of a predetermined value in response to output from the A-D converter 11'. If the decision is of yes, the select memory 21 stores the frequency data fn at a step S324. Thereafter the operation step is upgraded to S325. If the signal strength of the tuner circuit 2' is below the predetermined value, on the other hand, the select memory 21 stores no frequency data fn but the operation step is directly upgraded to S325.

At the step S325, a decision is made as to whether or not the value of the counter n reaches N. That is, a decision is made as to whether or not search is completed for the entire frequency data data included in the AF list stored in the data memory 20. If the value of the counter n is not N, i.e., if frequency data to be searched still remain in the data memory 20, the counter n is incremented by 1 at a step S326. Thereafter the first timer 22a is started from a cleared state at a step S327. Thus, counting of the second half (3 ms) in the aforementioned interruption period is started. Thereafter the frequency data fp is read from the data memory 20 at a step S328, and supplied to the local oscillation circuit of the tuner circuit 2'. Thus, the tuner circuit 2' is tuned to the said frequency. Thereafter a decision is made at a step S329 as to whether or not the first timer 22a counts 3 ms. If the decision is of yes, the muting operation in the amplifier 5' is released at a step S330. Thus, the speaker 6 again reproduces the program signal.

Thereafter the first timer 22a is re-started from a cleared state at a step S331. Thus, counting of a period (0.5 s) for receiving the ordinary program signal is started. Thereafter a decision is made at a step S332 as to whether or not the signal strength of the tuner circuit 2' is in excess of a predetermined value, in response to the output from the A-D converter 11'. If the decision is of no, a second timer 22b performs counting at a step S333. If the decision at the step S332 is of yes, on the other hand, the second timer 22b is cleared at a step S334. Thereafter a decision is made at a step S335 as to whether or not the first timer 22a counts 0.5 s. If the decision is of yes, a decision is made at a step S336 as to whether or not "1" is set in the flag register F. "1" is not set in the flag register F until the search is completed for the entire frequency data included in the AF list stored in the data memory 20, and hence the operation step is returned to S317. Then, the remaining frequency data in the data memory 20 are searched.

When the search is completed for the entire frequency data included in the AF list stored in the data memory 20, the value of the counter n reaches N and this is decided at a step S325, whereby the operation step is upgraded to S337. At the step S337, "1" is set in the flag register F. Thereafter a decision is made at a step S338 as to whether or not the select memory 21 stores frequency data. If the decision is of no, the AF lamp 8C is flashed at a step S339. Then, the operation is returned to the step S327. In this case, it is decided that "1" is set in the flag register F at a step S336 after the operation through the steps S327 to S335, and hence the operation step is returned to S315. Thus, the select memory 21 is cleared and "1" is set in the counter n while "0" is set in the flag register F, whereafter search for frequency data is re-started from an initial state. If it is decided that the select memory 21 stores frequency data at the step S338, on the other hand, the AF lamp 8C is lit at a step S340.

Thereafter a decision is made at a step S341 as to whether or not the second timer 22b counts at least 22 seconds, i.e., whether or not the signal strength of the tuner circuit 2' for the ordinary program signal is continuously lowered below a predetermined value for at least 22 seconds. If the decision is of no, there is no need to change the tuning frequency for the ordinary program signal, and hence the operation step is returned to the step S327. If the decision is of yes, on the other hand, the receiving state of the tuner circuit 2' for the ordinary program signal is deteriorated and hence processing for changing the frequency of the tuner circuit 2' for receiving the ordinary program signal is performed as follows: At a step S342, the first timer 22a is started from a cleared state. thereafter the lowermost frequency data is read from the select memory 21 at a step S343, and supplied to the local oscillation circuit of the tuner circuit 2'. Thus, the tuner circuit 2' is tuned to the said frequency. Thereafter PI codes extracted by the RDS decoder 7 are read at a step S344. This reading of the PI codes is continued until the first timer 22a counts 0.2 s (step S345). The PI codes are read for 0.2 s for the reason that sufficient reading can be performed within 0.2 s since the PI codes are transmitted 11 times per second. When the reading is completed at the step S345, the PI codes are checked at a step S346. That is, a decision is made as to whether or not PI codes (those in receiving of the ordinary program signal) previously stored in the data memory 20 at the aforementioned step S304 coincide with the PI codes obtained from the current receiving output of the tuner circuit 2'. If the decision is of no, the data of the current tuning frequency in the tuner circuit 2' is deleted from the select memory 21 at a step S347. Then, a decision is made at a step S348 as to whether or not frequency data still remain in the select memory 21, and if the decision is of yes, subsequent frequency data is read from the select memory 21 for checking the PI codes (steps S342 to S346). When no coincidence of the PI codes is detected even if the frequency data stored in the select memory 21 are entirely read to tune/control the tuner circuit 2', it is decided at a step S348 that no frequency data remain in the select memory 21, and the AF lamp 8C is flashed at a step S349. Thereafter the operation step is returned to S327, to tune the tuner circuit 2' again through the frequency data fp and to re-start the search for the frequency data from an initial state. If coincidence of the PI codes is decided at the step S346, on the other hand, the tuning frequency data is changed at a step S350. That is, the previous frequency data fp (frequency data based on operation of the preset key 12 or 13) is replaced by frequency data f currently read from the select memory 21. Thereafter this frequency data f is processed as the frequency data fp. Therefore, the tuning frequency for the ordinary program signal is changed to the frequency data f. Thereafter the AF lamp 8C is flashed and the second timer 22b is cleared at a step S351. Then the operation step is returned to S330. The search for the frequency data is re-started from an initial state.

In the above structure, the processing through the steps S319 to S323 or through the steps S319 to S321, S333 to S327 and S323 is performed during the counting operation of the first timer 22a, and the time required for this processing is made extremely shorter than 3 ms.

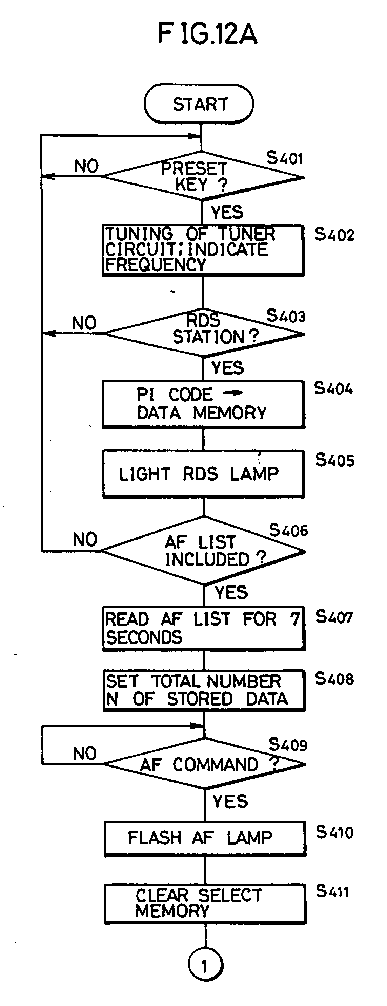

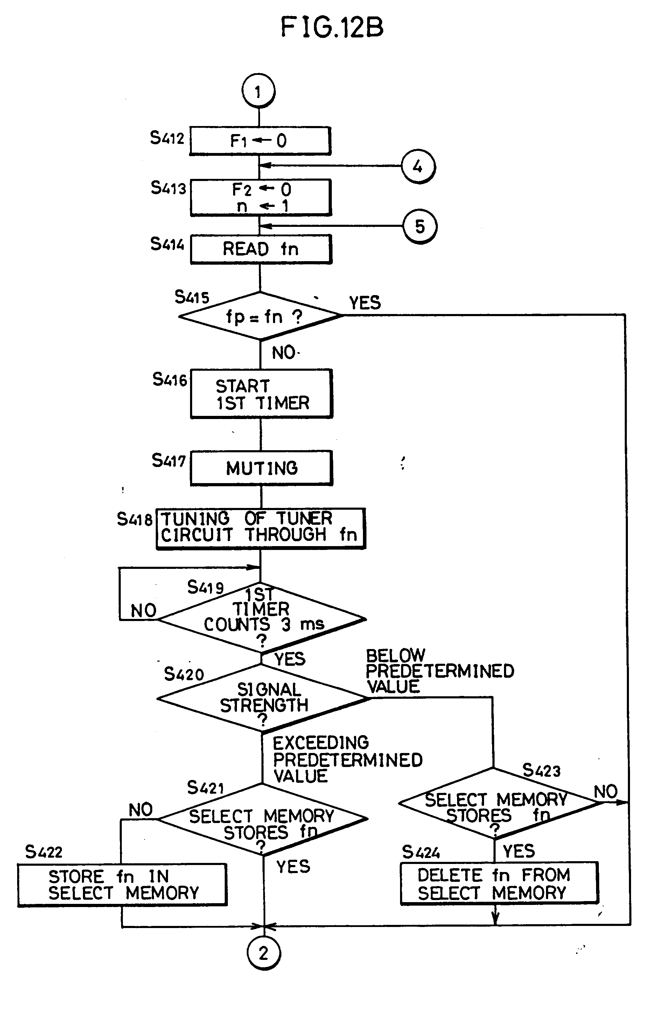

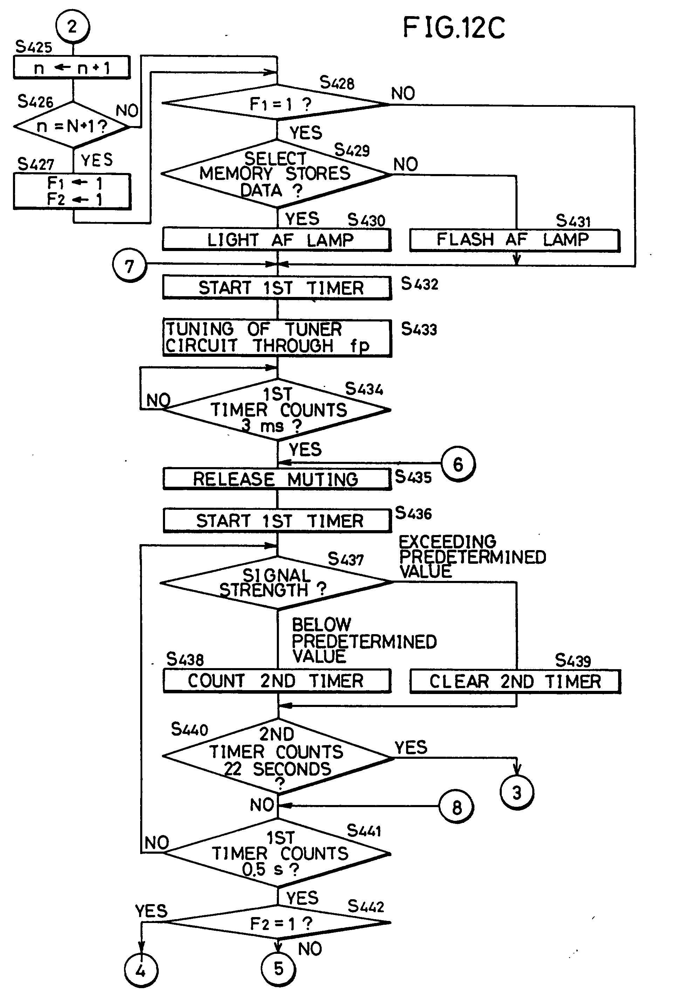

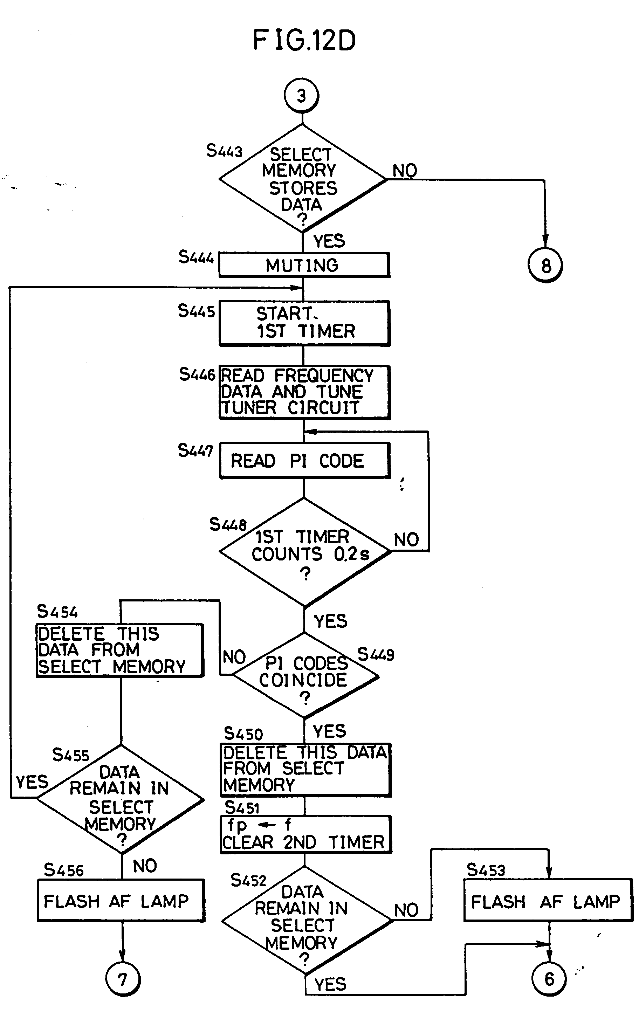

In the aforementioned fifth embodiment, the count time of the second timer 22b is decided whenever the search is completed for the entire frequency data included in the AF list stored in the data memory 20 (step S341), thereby to decide whether or not it is necessary to change the tuning frequency for the ordinary program signal, similarly to the aforementioned first embodiment. Therefore, when it is decided that the tuning frequency must be changed, there is a strong probability that the select memory 21 stores frequency data which is at a signal strength exceeding the predetermined value, and changeability of the tuning frequency is increased. In the fifth embodiment, however, the search for frequency data is repeated from an initial state when search for one cycle is completed immediately before the second timer 22b counts 22 seconds, similarly to the aforementioned first embodiment. Therefore, the processing for changing the tuning frequency is delayed by a period (in the fifth embodiment, about 13 seconds when the AF list includes 25 frequency data) required for the one cycle search. Figs. 12A to 12D show a sixth embodiment of the present invention, which can solve such a problem.

### Sixth Embodiment

Figs. 12A to 12D are flow charts for illustrating the operation of the sixth embodiment. A hard circuit employed in the sixth embodiment is similar to that of the fifth embodiment (see Fig. 9). That is, the operation program written in the program memory 19 is simply changed to that shown in Figs. 12A to 12D. The operation of the sixth embodiment is now described with reference to Figs. 12A to 12D.

Upon power supply, the preset key 12 or 13 is operated and frequency data fp corresponding to the operated preset key 12 or 13 is read from the data memory 20 and supplied to the local oscillation circuit of the tuner circuit 2' and the driving circuit 9 (steps S401 and S402). Thus, the tuner circuit 2' is tuned to the said frequency, which in turn is indicated on the frequency indicator 8A. If the station currently communicating with the tuner circuit 2' is an RDS station, PI codes included in RDS data are stored in the data memory 20 and the RDS lamp 8B is lit (steps S403 and S405). Then, a decision is made as to whether or not RDS data extracted by the RDS decoder 7 include an AF list, and if the decision is of yes, the AF list is read for seven seconds and stored in the data memory 20 (steps S406 and S407). Then, the total number of frequency data included in the AF list stored in the data memory 20 is set as N (step S408).

When the AF key 16 is operated, the AF lamp 8C is flashed and the select memory 21 is cleared (steps S409 to S411). Then, "0" is set in a flag register F1 (step S412). Further, "0" is set in another flag register F2 and "1" is set in the counter n (step S413). Thereafter frequency data fn corresponding to the count value of the counter n is read from the data memory 20, and a decision is made as to whether or not the frequency data fn coincides with the aforementioned frequency data fp (based on the operation of the preset key 12 or 13) (steps S414 and S415). If the frequency data fn is not coincident with the frequency data fp, the first timer 22a is started from a cleared state while muting of the amplifier 5' is started (steps S416 and S417). Then, the aforementioned frequency data fn is supplied to the local oscillation circuit of the tuner circuit 2' (step S418). Thus, the tuner circuit 2' is tuned to the said frequency. When the first timer 22a counts 3 ms in this state, a decision is made as to whether or not the signal strength of the tuner circuit 2' is in excess of a predetermined value, in response to output from the A-D converter 11 (step S420). If the decision is of yes, the frequency data fn is stored in the select memory 21, while the frequency data fn is deleted from the select memory 21 if the decision is of no (steps S421 to S424). If the select memory 21 already stores the frequency data fn at the step S421, no storage of the frequency data fn is performed. Similarly, if the select memory 21 stores no frequency data fn at the step S423, no deletion of the frequency data fn is performed. After the processing through the steps S421 to S424, the operation step is upgraded to S425. If coincidence of the frequency data fp and fn is decided at the aforementioned step S415, the operation step is directly upgraded to S425. At the step S425, the counter n is incremented by 1. Then, a decision is made as to whether or not the value of the counter n is N + 1 (step S426). If the decision is of no, search for one cycle is not yet completed and hence the operation step is upgraded to S428. If the value of the counter n is N + 1, on the other hand, one-cycle search is completed and "1" is set in the flag registers F1 and F2 respectively (step S427). Thereafter the operation step is upgraded to S428. At the step S428, a decision is made as to whether or not "1" is set in the flag register F1. If the decision is of yes, indication control of the AF lamp 8C is performed in response to whether or not the select memory 21 already stores frequency data (steps S429 to S431). That is, the AF lamp 8C is lit if the select memory 21 stores frequency data, while the same is flashed if the select memory 21 stores no frequency data. If "0" is set in the flag register F1, on the other hand, the cycle of first search is not yet completed and hence the AF lamp 8C is continuously flashed as a preparation stage even if the select memory 21 stores frequency data. The preparation stage is for about 13 seconds at the maximum, and no request for changing the tuning frequency in the first mode is generated during this stage, since the second timer 22b counts 22 seconds.

Then, the first timer 22a is started from a cleared state, to start counting of the second half (3 ms) of the interruption period shown in Fig. 10B (step S432). Then, the tuner circuit 2' is tuned through the frequency data fp (step S433). When the first timer 22a counts 3 ms, the muting state is released (steps S434 and S435).

Thereafter the first timer 22a is re-started from a cleared state at a step S436, to start operation for counting 0.5 s for receiving an ordinary program signal. Then, a decision is made as to whether or not the signal strength of the tuner circuit 2' is in excess of a predetermined value, and if the decision is of no, the second timer 22b performs counting operation while the same is cleared if the decision is of yes (steps S437 to S439). Thereafter a decision is made at a step S440 as to whether or not the second timer 22b counts at least 22 seconds. If the decision is of no, there is no need to change the tuning frequency and a decision is made as to whether or not "1" is set in the flag register F2 after the first timer 22a counts 0.5 sec. (steps S441 and S442). If "0" is set in the flag register F2, the operation step is returned to S414 to perform search for frequency data remaining in the AF list stored in the data memory 20. If "1" is set in the flag register F2, on the other hand, the operation step is returned to S413. In this case, the search is completed for entire frequency data included in the AF list stored in the data memory 20, and hence search is re-started from the first frequency data.

If it is decided that the second timer 22b counts at least 22 seconds at the step S440, the following processing is performed for changing the tuning frequency: At a step S443, a decision is made as to whether or not the select memory 21 stores frequency data. If the decision is of no, there is no frequency data of which signal strength is in excess of a predetermined value and hence the operation step is returned to S441, to repeat the search for frequency data. If the select memory 21 stores frequency data, on the other hand, muting in the amplifier 5' is started and the first timer 22a is started from a cleared state (steps S444 and S445). Then the lowermost frequency data is read from the select memory 21, and supplied to the local oscillation circuit of the tuner circuit 2' (step S446). Thus, the tuner circuit 2' is tuned to the frequency f. Then, reading of PI codes is performed until the first timer 22a counts 0.2 s (steps S447 and S448). Then, a decision is made as to whether or not the PI codes corresponding to the frequency data f (those read at the step S447) coincide with those corresponding to the frequency data fp (PI codes stored in the data memory 20 at the step S404). If the decision is of yes, the frequency data f is deleted from the select memory 21 (step S450). Then this frequency data f is set as the frequency data fp and the second timer 22b is cleared (step S451). Thus, the tuning frequency of the tuner circuit 2' for receiving the ordinary program signal is changed. Then, a decision is made as to whether or not frequency data remain in the select memory 21 (step S452). If the decision is of yes, the operation step is returned to S453. In this case, the AF lamp 8C is continuously lit. When the select memory 21 stores no frequency data, on the other hand, the AF lamp 8C is flashed at the step S453, and the operation step is returned to S435.

Description is now made on operation performed when no coincidence of the PI codes is decided at the step S449. In this case, the program signal received in the tuner circuit 2', which is tuned through the frequency data f, is different from that received in the tuner circuit 2', which is tuned through the frequency data fp, and hence the frequency data f is deleted from the select memory 21 at a step S454. Then, a decision is made as to whether or not frequency data still remain in the select memory 21 (step S455). If the decision is of yes, the operation step is returned to S445, and subsequent frequency data is read from the select memory 21. If no frequency data remains in the select memory 21, on the other hand, the AF lamp 8C is flashed at a step S456 and the operation step is returned to S432.

In the aforementioned structure, the operation through the steps S420 to S432 is performed during the counting operation of the first timer 22a, and the time required for this processing is made extremely shorter than 3 ms, similarly to the fifth embodiment.

According to the sixth embodiment as hereinabove described, deterioration of the state of the tuner circuit 2' for receiving the ordinary program signal is decided at the step S440 during the search for the frequency data similarly to the aforementioned second embodiment, whereby the processing for changing the tuning frequency can be immediately performed when a decision is made on the deterioration of the receiving state.

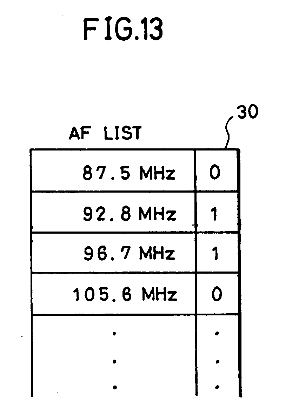

In each of the first to sixth embodiments as hereinabove described, the select memory is provided independently of the data memory, to make the select memory store the frequency data searched from the AF list stored in the data memory. Alternatively, flag areas 30 may be provided in correspondence to respective frequency data storage areas of an AF list table provided in the data memory as shown in Fig. 13, to store the result of search for the frequency data in the flag areas 30. The select memory can be omitted in this case.

Although the present invention has been described and illustrated in detail, it is clearly understood that the same is by way of illustration and example only and is not to be taken by way of limitation, the scope of the present invention being limited only by the terms of the appended claims.

## Claims

1. A receiver for receiving a broadcasting signal including various service data in addition to program signal and for reproducing the program signal, said service data including at least a list of frequency data of other stations giving the same program signal as the currently received one, said receiver comprising:
receiving means (2, 2') for receiving said broadcasting signal;
extracting means (7) for extracting said service data from said broadcasting signal received by said receiving means;
list storing means (20) for storing said list of frequency data of said other stations included in said service data extracted by said extracting means;
search means (3, 2') for searching for frequency data of other stations having a signal strength exceeding a predetermined value from said list of said frequency data stored in said list storing means;
search result storing means (21) for storing the frequency data obtained as a result of a search made by said search means;
level detecting means (10, 11, 11') for detecting the signal strength of said broadcasting signal received by said receiving means;
decision means (18) in response to output from said level detecting means for deciding whether or not the receiving state is deteriorated; and
change means for controlling the tuning frequency of said receiving means to one of said frequency data stored in the search result storing means in response to a decision on deterioration of the receiving state made by said decision means, thereby to change the currently received program signal to the same program signal transmitted from another station.

2. A receiver in accordance with claim 1, wherein said receiving means (2, 2') includes two tuner circuits.

3. A receiver in accordance with claim 2, wherein said receiving means (2, 2') includes:
a first tuner circuit (2) for reproducing a program signal, and
a second tuner circuit (3) employed for said search for frequency data made by said search means,
said extracting means (7) extracts said service data from a broadcasting signal received by said second turner circuits, and
said level detecting means (10, 11, 11') detects the signal strength of said broadcasting signal received by said first tuner circuit (2).

4. A receiver in accordance with claim 3, wherein said search means (3, 2') sequentially supplies frequency data stored in said list storing means to said second tuner circuit for sequentially changing its tuning frequency to search for frequency data in response to signal strength of each receiving output obtained from said second tuner circuit, and
said change means controls the tuning frequency of said first tuner circuit in response to a decision on deterioration of the receiving state made by said decision means.

5. A receiver in accordance with claim 4, wherein said search means (3, 2') performs said search for frequency data in a cyclic manner, to update searched frequency data every cycle.

## Patentansprüche

1. Empfänger zum Empfangen eines Rundfunksignals, das zusätzlich zum Programmsignal verschiedene Servicedaten enthält, und zur Wiedergabe des Programmsignals, wobei die Servicedaten wenigstens eine Liste der Frequenzdaten anderer Stationen enthalten, die das gleiche Programmsignal wie das gerade empfangene senden, mit:
einer Empfangseinrichtung (2, 2') zum Extrahieren des Rundfunksignals;
einer Trenneinrichtung (7) zum Ausblenden der Servicedaten aus dem Rundfunksignal, das von der Empfangseinrichtung empfangen worden ist;
Listenspeichermitteln (20) zum Speichern der Liste der Frequenzdaten der anderen Stationen, die in den von der Trenneinrichtung ausgeblendeten Servicedaten enthalten ist; einer Sucheinrichtung (3, 2') zum Suchen nach Frequenzdaten anderer Stationen, die eine Signalstärke haben, die einen vorbestimmten Wert übersteigt, aus der Liste der Frequenzdaten, die in den Listenspeichermitteln gespeichert sind; Suchergebnis-Speichermitteln (21) zum Speichern der Frequenzdaten, die als ein Ergebnis einer Suche, die durch die Sucheinrichtung durchgeführt worden ist, erhalten worden sind;
Pegeldetektormitteln (10, 11, 11') zum Detektieren der Signalstärke des Rundfunksignals, das von der Empfangseinrichtung empfangen wird;
Entscheidungsmitteln (18), die in Abhängigkeit vom Ausgangssignal der Pegeldetektormittel entscheiden, ob der Empfangszustand verschlechtert ist oder nicht; und
Änderungsmitteln zum Steuern der Abstimmfrequenz der Empfangsmittel auf eine Frequenz der Frequenzdaten, die in den Suchergebnis-Speichermitteln gespeichert sind, in Abhängigkeit von einer von den Entscheidungsmitteln getroffenen Entdeckung einer Verschlechterung des Empfangszustandes, wodurch das laufend empfangene Programmsignal auf das gleiche Programmsignal, das von einer anderen Station gesendet wird, umgeschaltet wird.

2. Empfänger nach Anspruch 1,
wobei die Empfangseinrichtung (2, 2') zwei Tunerschaltungen aufweist.

3. Empfänger nach Anspruch 2, wobei die Empfangseinrichtung (2, 2') aufweist:
eine erste Tunerschaltung (2) zum Wiedergeben eines Programmsignals, und
eine zweite Tunerschaltung (3), die für die Suche nach den Frequenzdaten, welche von der Sucheinrichtung durchgeführt wird, verwendet wird;
wobei die Trenneinrichtung (7) die Servicedaten aus einem durch die zweite Tunerschaltung empfangenen Rundfunksignal extrahiert; und
die Pegeldetektormittel (10, 11, 11') die Signalstärke des Rundfunksignals detektieren, das von der ersten Tunerschaltung (2) empfangen wird.

4. Empfänger nach Anspruch 3,
wobei die Sucheinrichtung (3, 2') sequentiell Frequenzdaten, die in den Listenspeichermitteln gespeichert sind, der zweiten Tunerschaltung zuführt, um sequentiell deren Tuner-frequenz zu ändern, um nach Frequenzdaten in Abhängigkeit von der Signalstärke jedes von der zweiten Tunerschaltung erhaltenen Empfangsausgangssignals zu suchen; und wobei die Änderungsmittel die Abstimmfrequenz der ersten Tunerschaltung in Abhängigkeit von einer Entscheidung, basierend auf der Verschlechterung des Empfangszustandes, die von den Entscheidungsmitteln getroffen worden ist, steuern.

5. Empfänger nach Anspruch 4,
wobei die Sucheinrichtung (3, 2') die Suche nach Frequenzdaten in zyklischer Art und Weise durchführt, um die gesuchten Frequenzdaten bei jedem Zyklus zu aktualisieren.

## Revendications

1. Récepteur pour recevoir un signal de radiodiffusion comprenant diverses données de service en plus d'un signal de programme et pour reproduire le signal de programme, lesdites données de service comportant au moins une liste de données de fréquence des autres stations donnant le même signal de programme que le signal reçu ordinairement, ledit receveur comportant :
un moyen de réception (2, 2') pour recevoir ledit signal de radiodiffusion;
un moyen d'extraction (7) pour extraire lesdites données de service dudit signal de radiodiffusion reçu par ledit moyen de réception;
un moyen de mémorisation de liste (20) pour stocker ladite liste de données de fréquence desdites autres stations incluse dans lesdites données de service extraites par ledit moyen d'extraction;
un moyen de recherche (3, 2') pour rechercher les données de fréquence des autres stations ayant une intensité du signal dépassant une valeur prédéterminée dans ladite liste desdites données de fréquence stockées dans ledit moyen de mémorisation de liste;
un moyen de mémorisation de résultat de recherche (21) pour stocker la donnée de fréquence obtenue comme résultat d'une recherche effectuée par ledit moyen de recherche;
un moyen de détection de niveau (10, 11, 11') pour détecter l'intensité de signal dudit signal de radiodiffusion reçu par ledit moyen de réception;
un moyen de décision (18) en réponse à la sortie dudit moyen de détection de niveau pour décider si oui ou non l'état de réception est détérioré; et
un moyen de changement pour commander la fréquence d'accord dudit moyen de réception à l'une desdites données de fréquence stockées dans le moyen de mémorisation de résultat de recherche en réponse à une décision sur la détérioration de l'état de réception effectuée par ledit moyen de décision, pour changer ainsi le signal de programme reçu ordinairement dans le même signal de programme transmis à partir d'une autre station.

2. Récepteur selon la revendication 1, caractérisé en ce que ledit moyen de réception (2, 2') comprend deux circuits d'accord.

3. Récepteur selon la revendication 2, dans lequel ledit moyen de réception (2, 2') comprend :
un premier circuit d'accord (2) pour reproduire un signal de programme, et
un second circuit d'accord (3) employé pour ladite recherche des données de fréquence effectuée par ledit moyen de recherche,
ledit moyen d'extraction (7) extrait lesdites données de service d'un signal de radiodiffusion reçu par ledit second circuit d'accord, et
ledit moyen de détection de niveau (10, 11, 11') détecte l'intensité dudit signal de radiodiffusion reçu par ledit premier circuit d'accord (2).

4. Récepteur selon la revendication 3, dans lequel ledit moyen de recherche (3, 2') fournit séquentiellement des données de fréquence stockées dans ledit moyen de mémorisation de liste audit second circuit d'accord pour changer séquentiellement sa fréquence d'accord afin de rechercher des données de fréquence en réponse à l'intensité de signal de chaque sortie de réception obtenue à partir du second circuit d'accord, et
ledit moyen de changement commande la fréquence d'accord dudit premier circuit d'accord en réponse à une décision quant à la détérioration de l'état de réception effectuée par ledit moyen de décision.

5. Récepteur selon la revendication 4, dans lequel ledit moyen de recherche (3, 2') exécute ladite recherche des données de fréquence d'une manière cyclique, afin de mettre à jour les données de fréquence recherchées lors de chaque cycle.
